# EUROPEAN PATENT APPLICATION

(11) **EP 4 768 772 A1**
(43) Date of publication of application: **01.07.2026**
(21) Application number: 24922475.9
(22) Date of filing: 12.12.2024
(51) Int. Cl.: F16M 11/04, F16M 11/06

(54) **DISPLAY APPARATUS**

(30) Priority: 01.02.2024 KR 20240016126
(71) Applicant: Samsung Electronics Co., Ltd, Suwon-si, Gyeonggi-do 16677 (KR)
(72) Inventor: CHOI, Suan, Suwon-si, Gyeonggi-do 16677 (KR); CHUN, Bumho, Suwon-si, Gyeonggi-do 16677 (KR)
(74) Representative: Appleyard Lees IP LLP
(86) International application number: PCT/KR2024/096827
(87) International publication number: WO 2025/164967

(57) **Abstract**

A display apparatus includes: a display; and a stand configured to support the display. The stand includes: a mounting part detachably mountable on the display; and a supporting part rotatable in a first direction to a locking position or an unlocking position. A movement of the supporting part with respect to the mounting part is restricted in a state in which the supporting part is in the locking position. The movement of the supporting part with respect to the mounting part is allowed in a state in which the supporting part is in the unlocking position. In a state in which the supporting part is in the locking position, the mounting part is rotatable in a second direction different from the first direction.

## Description

### [Technical Field]

The present disclosure relates to a display apparatus including a stand.

### [Background Art]

A display apparatus is a type of output apparatus that converts obtained or stored electrical information into visual information and displays the visual information to a user.

The display apparatus may include a self-emissive display panel, such as an organic light-emitting diode (OLED) or a non-self-emissive display panel, such as a liquid crystal display (LCD).

The display apparatus may include a display that includes the above-described display panel and displays an image, and a stand that supports the display.

The display apparatus may support additional functions using the above-described stand, such as a height adjustable stand (Has) for adjusting the height of the display upward and downward or a Tilt for tilting the display forward and backward.

### [Disclosure]

### [Technical Problem]

According to an aspect of the present disclosure, provided is a display apparatus which may have an improved usability.

According to an aspect of the present disclosure, provided is a display apparatus including a stand which may have a relatively small size.

According to an aspect of the present disclosure, provided is a display apparatus which may allow adjustment of the height and angle of the display.

Technical problems to be achieved by the present specification are not limited to the above-mentioned technical problems, and other technical problems not mentioned will be clearly understood by those skilled in the art to which the disclosure belongs from the following description.

### [Technical Solution]

According to an aspect of the disclosure, a display apparatus includes: a display; and a stand configured to support the display. The stand includes: a mounting part detachably mountable on the display; and a supporting part rotatable in a first direction to a locking position or an unlocking position. A movement of the supporting part with respect to the mounting part is restricted in a state in which the supporting part is in the locking position. The movement of the supporting part with respect to the mounting part is allowed in a state in which the supporting part is in the unlocking position. In a state in which the supporting part is in the locking position, the mounting part is rotatable in a second direction different from the first direction.

The mounting part may include a guide portion extending in an upper-lower direction in a state in which the mounting part is mounted on the display. The supporting part may include a connector that may be configured to be movably coupled to the guide portion in a state in which the supporting part is in the unlocking position.

The mounting part may include a fixing portion that may be configured to fix the connector to a fixed position in a state in which the supporting part is in the locking position.

The supporting part may further include: a base; and a leg extending from the base. The connector may further include: a connector body on the guide portion; and a connecting protrusion extending from the connector body toward the leg and may be configured to connect the connector body to the leg.

The first direction may be a direction in which the connector rotates about a central axis of the connecting protrusion.

The supporting part may further include a hinge shaft extending in a direction intersecting with a direction in which the connecting protrusion extends. The second direction may be a direction in which the mounting part rotates about a central axis of the hinge shaft together with the connector in a state in which the supporting part is in the locking position.

The guide portion may include: a seating portion; and a guide hole on an inner side of the seating portion. At least a portion of the connector body may be seated on the seating portion. The connecting protrusion may pass through the guide hole.

The connector body may include: a convex portion on an edge of the connector body; and a concave portion that may be configured to seat the convex portion thereon. In a state in which the convex portion is seated on the concave portion, the connector may be fixed to the fixed position by the fixing portion.

The stand may include: first stand disposed at one end of the display; and second stand disposed at another end of the display.

The fixing portion may include: a first fixing portion that may be configured to fix the mounting part at a first height in a state in which the supporting part is in the locking position; and a second fixing portion that may be configured to fix the mounting part at a second height different from the first height in a state in which the supporting part is in the locking position.

The display may include a display panel and a rear cover configured to cover a rear of the display panel. The rear cover may include a mounting groove configured to mount the mounting part therein.

The mounting part may include a first magnetic body. The rear cover may include: a seating surface that may be configured to seat the mounting part thereon in a state in which the mounting part is mounted in the mounting groove; and a second magnetic body that may be disposed on a side opposite to the mounting part with respect to the seating surface in a state in which the mounting part is mounted in the mounting groove.

The mounting part may further include a hook at one end of the mounting part. The rear cover further may include a hook insertion groove at one end of the mounting groove. At least a portion of the hook may be configured to be inserted into the hook insertion groove in a state in which the mounting part is mounted in the mounting groove.

The mounting part may include an elastic body at an upper end of the hook and may be configured to press the hook downward in a state in which the mounting part is mounted in the mounting groove. The hook may include an inclined portion at a lower end of the hook and may be configured to guide the hook upward in a state in which the mounting part is mounted in the mounting groove.

The mounting part may further include: a case that may be configured to accommodate at least a portion of the hook; and a sliding part connected to the hook and provided on an outer surface of the case. The sliding part may be configured to move upward and downward with respect to the case together with the hook in a state in which the mounting part is mounted in the mounting groove.

According to another aspect of the disclosure a display apparatus includes: a display; and a stand configured to support the display. The stand includes: a mounting part detachably mountable on the display and including a guide portion extending in an upper-to-lower direction in a state in which the mounting part is mounted to the display, and a fixing portion on the guide portion; and a supporting part including a connector configured to be movably coupled to the guide portion. The connector may be configured to be fixed to the fixing portion or be released from the fixing portion by rotating on the fixing portion in a first direction.

The supporting part may further include a base and a leg extending from the base. The connector may further include: a connector body on the guide portion; and a connecting protrusion extending from the connector body toward the leg and may be configured to connect the connector body to the leg. The connector may rotate about a central axis of the connecting protrusion.

In a state in which the connector is fixed to the fixing portion, the guide portion may extend in a direction parallel to a direction in which the leg extends.

In a state in which the connector is released from the fixing portion, the guide portion may extend in a direction perpendicular to the direction in which the leg extends.

The fixing portion may include: a first fixing portion at an upper end of the guide portion in a state in which the mounting part is mounted on the display; and a second fixing portion at a lower end of the guide portion in a state in which the mounting part is mounted on the display.

### [Description of Drawings]

The above and other aspects, features, and advantages of certain embodiments of the present disclosure will be more apparent from the following description taken in conjunction with the accompanying drawings, in which:
FIG. 1 is a view illustrating a display apparatus according to one or more embodiments;
FIG. 2 is a view illustrating the display apparatus shown in FIG. 1, when viewed from the rear;
FIG. 3 is a view illustrating a stand according to one or more embodiments;
FIG. 4 is an enlarged view of some components of the stand shown in FIG. 3;
FIG. 5 is an enlarged view of some components of the stand shown in FIG. 3 that are disassembled;
FIG. 6 is an enlarged view of some components of the stand shown in FIG. 3 in a disassembled state;
FIG. 7 is a view illustrating a connector according to one or more embodiments;
FIG. 8A is a front view of a stand according to one or more embodiments;
FIG. 8B is a front view of a stand according to one or more embodiments;
FIG. 8C is a front view of a stand according to one or more embodiments;
FIG. 9 is an enlarged view of portion A in the stand shown in FIG. 8A;
FIG. 10A is a view illustrating the stand shown in FIG. 8A, with a supporting part rotated counterclockwise;
FIG. 10B is a view illustrating the stand shown in FIG. 8A, with a supporting part rotated clockwise;
FIG. 11A is a view illustrating the stand shown in FIG. 10A, with a supporting part moved downward;
FIG. 11B is a view illustrating the stand shown in FIG. 10B, with a supporting part moved downward;
FIG. 12A is a view illustrating the stand shown in FIG. 11A, with a supporting part rotated clockwise;
FIG. 12B is a view illustrating the stand shown in FIG. 11A, with a supporting part rotated counterclockwise;
FIG. 13 is a side view of a stand according to one or more embodiments;
FIG. 14 is a view illustrating the stand shown in FIG. 13, with a mounting part rotated clockwise;
FIG. 15 is a view illustrating the stand shown in FIG. 13, with a mounting part rotated counterclockwise;
FIG. 16 is a side view of a stand according to one or more embodiments;
FIG. 17 is a view illustrating the stand shown in FIG. 16, with a mounting part rotated clockwise;
FIG. 18 is a view illustrating the stand shown in FIG. 16, with a mounting part rotated counterclockwise;
FIG. 19 is an enlarged view of a first hook in a stand according to one or more embodiments;
FIG. 20 is a side cross-sectional view of the first hook shown in FIG. 19;
FIG. 21 is a side cross-sectional view of the first hook shown in FIG. 20, when moved upward;
FIG. 22 is an enlarged view of a second hook in a stand according to one or more embodiments;
FIG. 23 is a side cross-sectional view of the second hook shown in FIG. 22;
FIG. 24 is a side cross-sectional view of the second hook shown in FIG. 23, when moved downward;
FIG. 25 is a view illustrating some components of a display that are disassembled;
FIG. 26 is a side cross-sectional view of a display apparatus according to one or more embodiments;
FIG. 27 is an enlarged view of portion B in the display apparatus shown in FIG. 26;
FIG. 28 is an enlarged view of portion C in the display apparatus shown in FIG. 26;
FIG. 29 is a view illustrating a display apparatus according to one or more embodiments; and
FIG. 30 is a view illustrating the display apparatus shown in FIG. 29, when viewed from the rear.

### [Modes of the Invention]

In addition, the same reference numerals or signs shown in the drawings of the disclosure indicate elements or components performing substantially the same function.

A singular expression may include a plural expression unless otherwise indicated herein or clearly contradicted by context.

The expressions "A or B," "at least one of A or/and B," or "one or more of A or/and B," A, B or C," "at least one of A, B or/and C," or "one or more of A, B or/and C," and the like used herein may include any and all combinations of one or more of the associated listed items.

The term of "and/or" includes a plurality of combinations of relevant items or any one item among a plurality of relevant items. Herein, the expressions "a first", "a second", "the first", "the second", etc., may simply be used to distinguish an element from other elements, but is not limited to another aspect (importance or order) of elements.

When an element (e.g., a first element) is referred to as being "(functionally or communicatively) coupled," or "connected" to another element (e.g., a second element), the first element may be connected to the second element, directly (e.g., wired), wirelessly, or through a third element.

**In** this disclosure, the terms "including", "having", and the like are used to specify features, numbers, steps, operations, elements, elements, or combinations thereof, but do not preclude the presence or addition of one or more of the features, elements, steps, operations, elements, elements, or combinations thereof.

When an element is said to be "connected", "coupled", "supported" or "contacted" with another element, this includes not only when elements are directly connected, coupled, supported or contacted, but also when elements are indirectly connected, coupled, supported or contacted through a third element.

Throughout the description, when an element is "on" another element, this includes not only when the element is in contact with the other element, but also when there is another element between the two elements.

Terms such as "unit", "module", and "member" may be embodied as hardware or software. According to embodiments, a plurality of "unit", "module", and "member" may be implemented as a single component or a single "unit", "module", and "member" may include a plurality of components.

The terms, such as "part", "device", "block", "member", "module", and the like may refer to a unit for processing at least one function or act. For example, the terms may refer to at least process processed by at least one hardware, such as a field-programmable gate array (FPGA) and/or application specific integrated circuit (ASIC), software stored in memories, or processors.

Reference numerals used for method steps are just used for convenience of explanation, but not to limit an order of the steps. Thus, unless the context clearly dictates otherwise, the written order may be practiced otherwise.

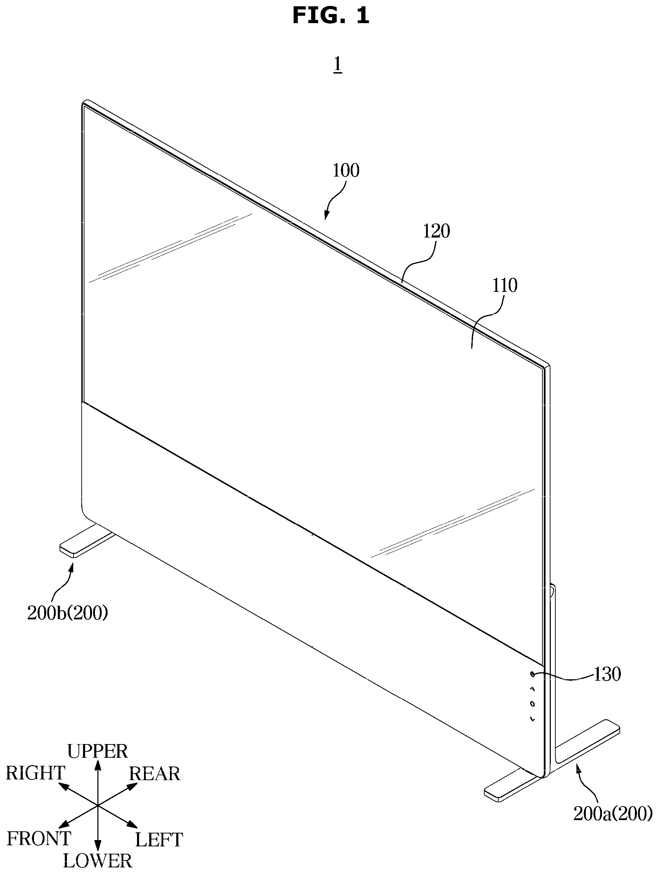

The terms "forward and backward direction", "forward," "backward," "lateral direction", "horizontal direction", "right side", "left side", "up and down direction", "vertical direction", "upward," "downward," etc. used in the following description are defined based on the drawings. Specifically, with reference to FIG. 1, the direction in which the display 100 faces is defined as the front, based on which the rear, left and right sides, and the upper and lower sides are defined.

Hereinafter, embodiments according to the present disclosure will be described in detail with reference to the accompanying drawings.

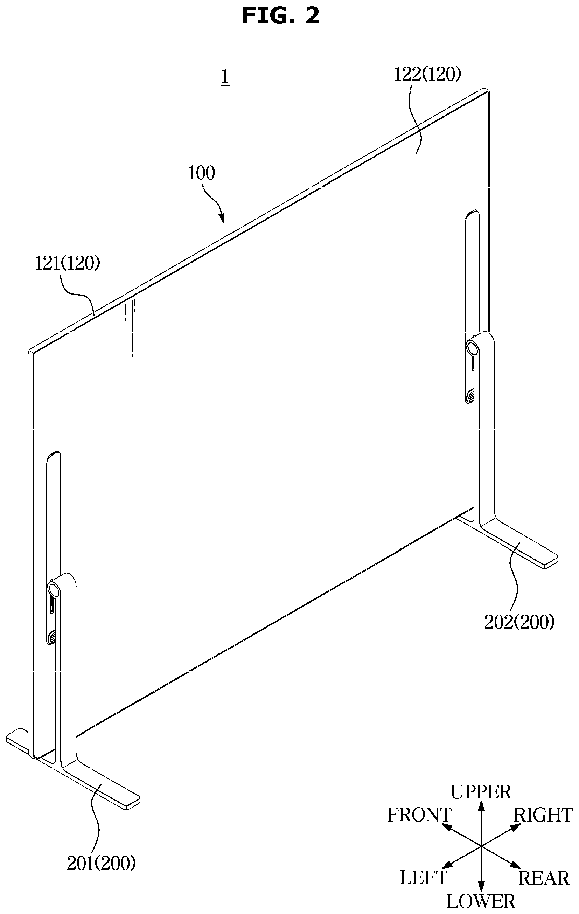

FIG. 1 is a view illustrating a display apparatus according to one or more embodiments. FIG. 2 is a view illustrating the display apparatus shown in FIG. 1, when viewed from the rear.

Referring to FIGS. 1 and 2, a display apparatus 1 may include a display 100. The display 100 is a device that displays information, data, and data in the form of characters, figures, graphs, images, and the like, and may include a television, a monitor, and the like.

The display 100 may include a display panel 110. The display panel 110 may be configured to display a screen. The display panel 110 may include a self-emissive display panel, such as an organic light-emitting diode (OLED) or a non-self-emissive display panel, such as a liquid crystal display (LCD). There is no limitation on the type of the display panel.

The display 100 may include a display housing 120. The display housing 120 may form an external appearance of the display 100. The display housing 120 may accommodate the display panel 110.

The display housing 120 may include an outer frame 121. The outer frame 121 may be provided in a box shape with the front and rear sides open. The display panel 110 may be coupled to the open front side of the outer frame 121. The outer frame 121 and the display panel 110 may be coupled in various methods.

The display housing 120 may include a rear cover 122. The rear cover 122 may be coupled to the open rear side of the outer frame 121. With such a configuration, the rear cover 122 may cover the rear side of the display panel 110. The outer frame 121 and the rear cover 122 may be coupled in various methods.

The display 100 may include an operating part 130. The operating part 130 may be provided to operate the display 100. For example, the operating part 130 may be provided on the front of the display 100. For example, the operating part 130 may be provided on the lower side of the display panel 110. However, there is no limitation on the position of the operating part 130.

Although not shown in the drawings, the display 100 may include a plurality of optical sheets, a backlight unit that emits light, a control module that controls the internal configuration of the display panel 110, and the like. Detailed descriptions thereof are omitted.

The display apparatus 1 may include a stand 200. The stand 200 may be provided to support the display 100. The stand 200 may be detachably coupled to a lower rear portion of the rear cover 122. With such a configuration, the display 100 may be disposed apart from the floor surface on which the display apparatus 1 is mounted.

The stand 200 may be provided in plural. For example, the stand 200 may include a first stand 201 and a second stand 202. For example, the first stand 201 may be disposed at one end of the display 100. For example, the first stand 201 may be detachably coupled to one end of the rear cover 122. For example, the second stand 202 may be disposed at the other end of the display 100. For example, the second stand 202 may be detachably coupled to the other end of the rear cover 122. Although the stand 200 is illustrated as two stands in the drawings, the number of stands 200 is not limited thereto.

The stand 200 may receive a load from the display 100. The greater the load received by the stand 200, the greater the risk of damage to the stand 200. **In** order to support the display 100 more stably without being damaged, the stand 200 may have a relatively large external appearance.

According to the concept of the present disclosure, since the stand 200 are provided in plural, the load received by each stand 200 from the display 100 may be reduced. For example, since the first stand 201 and the second stand 202 support the display 100, the load received by each stand 201, 202 may be less than the load received when a single stand 200 supports the display 100. Since each of the first stand 201 and the second stand 202 is provided to receive a less load, the first stand 201 and the second stand 202 may stably support the display 100 even with a relatively small external appearance. That is, each of the first stand 201 and the second stand 202 may have a relatively small size.

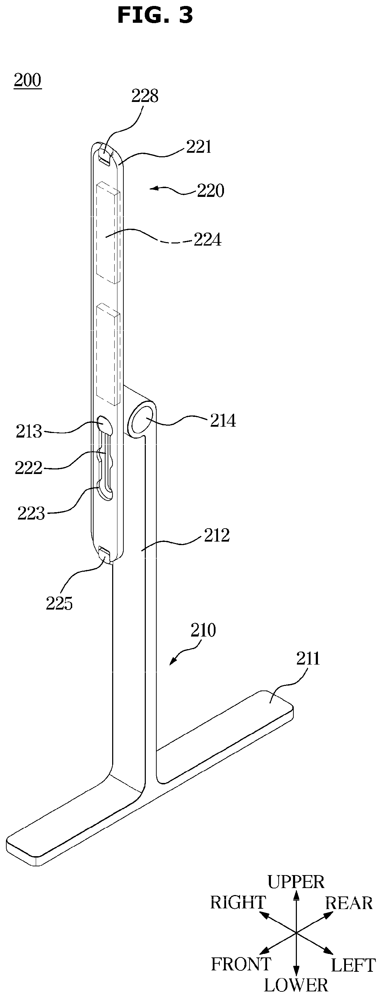

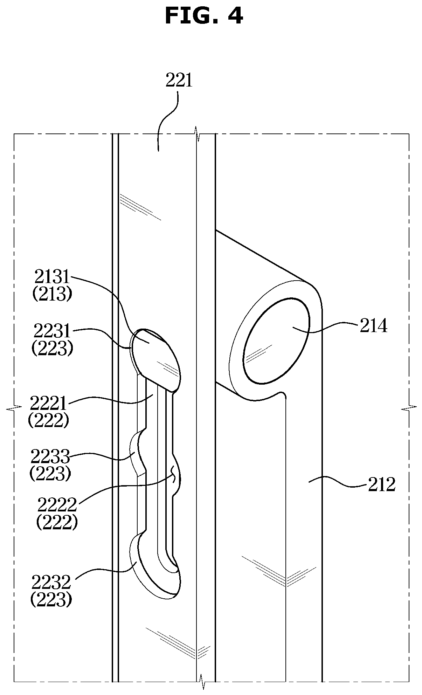

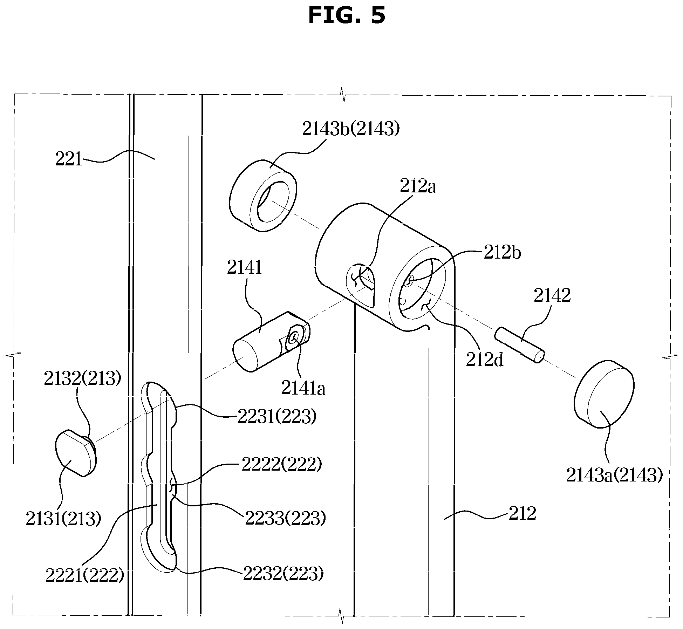

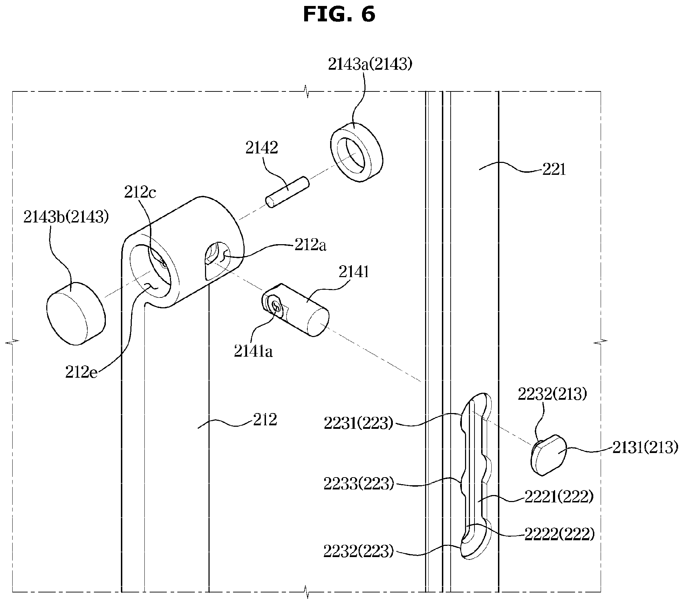

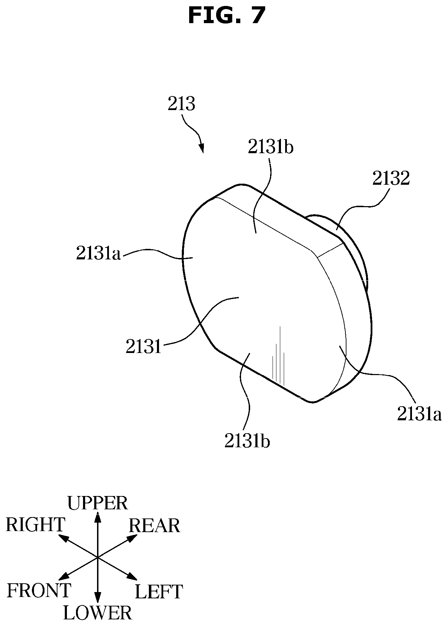

FIG. 3 is a view illustrating a stand according to one or more embodiments. FIG. 4 is an enlarged view of some components of the stand shown in FIG. 3. FIG. 5 is an enlarged view of some components of the stand shown in FIG. 3 that are disassembled. FIG. 6 is an enlarged view of some components of the stand shown in FIG. 3 in a disassembled state. FIG. 7 is a view illustrating a connector according to one or more embodiments.

Hereinafter, the configuration of the stand 200 will be described in detail with reference to FIGS. 3 to 7. Each of the first stand 201 and the second stand 202 may include the configuration of the stand 200 described below.

The stand 200 may include a supporting part 210. The supporting part 210 may be disposed on the floor surface on which the display apparatus 1 is mounted. Hereinafter, the floor surface on which the display apparatus 1 is disposed may be referred to as the floor surface without any additional modifiers.

The supporting part 210 may include a base 211. The base 211 may be placed on the floor surface. The base 211 may extend parallel to the floor surface. Specifically, the base 211 may extend in the front-back direction of the display 100. In the drawings, the base 211 is illustrated as a thin bar shape, but the shape of the base 211 is not limited thereto. For example, the base 211 may have a circular or rectangular shape.

The supporting part 210 may include a leg 212. The leg 212 may extend from the base 211. Specifically, the leg 212 may extend upward from the base 211.

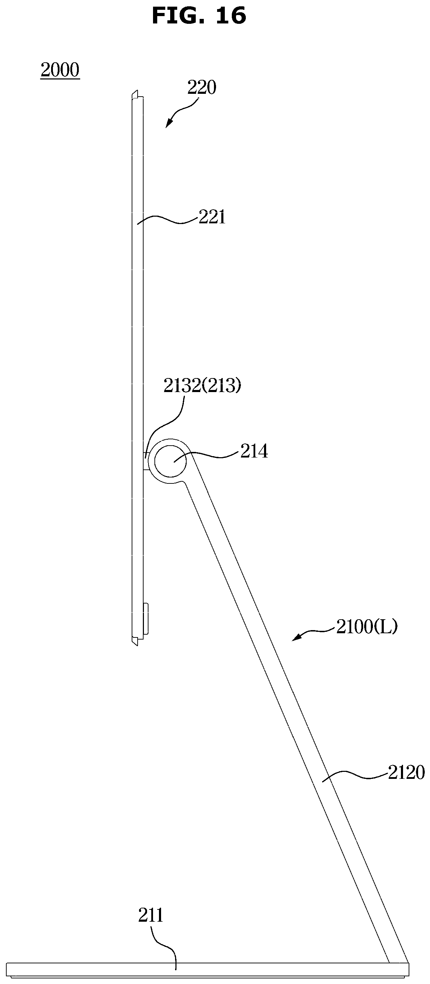

The leg 212 may extend vertically from the base 211. For example, the leg 212 may extend vertically from the center of the base 211. However, the connection relationship between the leg 212 and the base 211 and the extension direction of the leg 212 are not limited thereto. For example, referring to FIGS. 16 to 18, the leg 2120 may extend at an angle from one end of the base 211 relative to the base 211. This will be described in detail below.

The supporting part 210 may include a connector 213. The connector 213 may be coupled to a mounting part 220 to be described below. Specifically, the connector 213 may be movably coupled to a guide portion 222 to be described below. By the connector 213 being coupled to the mounting part 220, the supporting part 210 may be connected to the mounting part 220.

The connector 213 may include a connector body 2131. The connector body 2131 may be provided on a guide portion 222 to be described below. The connector body 2131 may be provided in a substantially flat shape. Details of the connector body 2131 will be described below.

The connector 213 may include a connecting protrusion 2132. The connecting protrusion 2132 may extend from the connector body 2131 toward the leg 212. Specifically, the connecting protrusion 2132 may extend from the center of the connector body 2131 toward an upper portion of the leg 212. **In** other words, the connecting protrusion 2132 may extend from the connector body 2131 toward a hinge body 2141 to be described below.

The connecting protrusion 2132 may connect the connector body 2131 to the leg 212. The connecting protrusion 2132 may be connected to the hinge body 2141 to be described below. Specifically, one end of the connecting protrusion 2132 may be connected to the hinge body 2141, and the other end of the connecting protrusion 2132 may be connected to the connector body 2131. By the connecting protrusion 2132 being connected to the hinge body 2141, the connector body 2131 may be connected to the leg 212.

The connecting protrusion 2132 may be formed in an approximately cylindrical shape. With such a configuration, the connecting protrusion 2132 may rotate about a central axis of the connecting protrusion 2132 while passing through a guide hole 2222 to be described below. This will be described in detail below.

The supporting part 210 may include a hinge 214. The hinge 214 may allow the connector 213 to be rotatably connected to the leg 212. That is, the connector 213 may be configured to rotate with respect to the leg 212 through the hinge 214. **In** addition, since the connector 213 is connected to a mounting part 220 to be described below, the mounting part 220 may rotate with respect to the leg 212 together with the connector 213.

The hinge 214 may include a hinge body 2141. One end of the hinge body 2141 may be connected to one end of the connecting protrusion 2132. The hinge body 2141 may extend in the same direction as the direction in which the connecting protrusion 2132 extends.

The hinge body 2141 may be inserted into a hinge body insertion groove 212a provided at the upper end of the leg 212. The hinge body insertion groove 212a may be recessed inward from the leg 212. The inner diameter of the hinge body insertion groove 212a may be larger than the outer diameter of the hinge body 2141. With such a configuration, the hinge body 2141 may rotate about a hinge shaft 2142 described below within a predetermined angular range.

The hinge 214 may include a hinge shaft 2142. The hinge shaft 2142 may form a central axis of rotation when the mounting part 220 rotates together with the connector 213. The hinge shaft 2142 may extend in a direction intersecting with the direction in which the connecting protrusion 2132 extends. That is, the hinge shaft 2142 may extend in a direction intersecting with the direction in which the hinge body 2141 extends. Accordingly, the hinge body 2141 may rotate about the hinge shaft 2142. **In** this case, the direction in which the hinge body 2141 rotates about the hinge shaft 2142 may be the same as the direction in which the mounting part 220 rotates with respect to the leg 212 together with the connector 213. **In** other words, the mounting part 220, the connector 213, and the hinge body 2141 may rotate in the same direction about the hinge shaft 2142. The hinge shaft 2142 may be provided in an approximately cylindrical shape.

The hinge shaft 2142 may be inserted into a first hinge shaft insertion hole 2141a provided at the other end of the hinge body 2141. The first hinge shaft insertion hole 2141a may extend in a direction intersecting with the direction in which the hinge body insertion groove 212a is recessed.

One end of the hinge shaft 2142 may be inserted into a second hinge shaft insertion hole 212b provided on the inner surface of the hinge body insertion groove 212a. The direction in which the second hinge shaft insertion hole 212b extends may be the same as the direction in which the first hinge shaft insertion hole 2141a extends. With such a configuration, the hinge shaft 2142 may be fixed to the leg 212.

The other end of the hinge shaft 2142 may be inserted into a third hinge shaft insertion hole 212c provided on the inner surface of the hinge body insertion groove 212a. The third hinge shaft insertion hole 212c may be provided on the opposite side of the second hinge shaft insertion hole 212b. The direction in which the third hinge shaft insertion hole 212c extends may be the same as the direction in which the first hinge shaft insertion hole 2141a extends. With such a configuration, the hinge shaft 2142 may be fixed to the leg 212.

The hinge 214 may include a hinge bracket 2143. The hinge bracket 2143 may fix the hinge shaft 2142. That is, the hinge shaft 2142 may be fixed while being inserted into the first hinge shaft insertion hole 2141a through the hinge bracket 2143.

The hinge bracket 2143 may include a first hinge bracket 2143a and a second hinge bracket 2143b. The first hinge bracket 2143a may fix one end of the hinge shaft 2142. The second hinge bracket 2143b may fix the other end of the hinge shaft 2142.

The first hinge bracket 2143a may be mounted in a first hinge bracket mounting groove 212d provided at the upper end of the leg 212. The first hinge bracket mounting groove 212d may be provided at one side of the hinge body insertion groove 212a. The first hinge bracket mounting groove 212d may be recessed inward from the leg 212. Specifically, the first hinge bracket mounting groove 212d may be recessed in a direction intersecting the direction in which the hinge body insertion groove 212a is recessed. The first hinge bracket mounting groove 212d may be in communication with the second hinge shaft insertion hole 212b.

The second hinge bracket 2143b may be mounted in a second hinge bracket mounting groove 212e provided at the upper end of the leg 212. The second hinge bracket mounting groove 212e may be provided on the other side of the hinge body insertion groove 212a. The second hinge bracket mounting groove 212e may be recessed inward from the leg 212. Specifically, the second hinge bracket mounting groove 212e may be recessed in a direction intersecting the direction in which the hinge body insertion groove 212a is recessed. The second hinge bracket mounting groove 212e may be in communication with the third hinge shaft insertion hole 212c.

The stand 200 may include a mounting part 220. The mounting part 220 may be detachably mountable on the display 100. Specifically, the mounting part 220 may be mounted on the lower rear portion of the rear cover 122. The mounting part 220 may be connected to the supporting part 210.

The mounting part 220 may include a case 221. The case 221 may form the external appearance of the mounting part 220. The case 221 may extend in the upper-to-lower direction. The case 221 may accommodate a first magnetic body 224 to be described below. The case 221 may accommodate at least a portion of a first hook 225 to be described below. The case 221 may accommodate at least a portion of a second hook 228 to be described below.

The mounting part 220 may include a guide portion 222. For example, the guide portion 222 may be provided in a lower portion of the case 221. The guide portion 222 may guide the movement of the connector 213.

The guide portion 222 may extend in the upper-to-lower direction. Specifically, the guide portion 222 may extend in the upper-to-lower direction while the mounting part 220 is mounted on the display 100. With such a configuration, the connector 213 may be guided by the guide portion 222 and may move in the upper-to-lower direction.

The guide portion 222 may include a seating portion 2221. At least a portion of the connector body 2131 may be seated on the seating portion 2221. That is, while at least a portion of the connector body 2131 is seated on the seating portion 2221, the connector 213 may move in the upper-to-lower direction.

The seating portion 2221 may be recessed from the front of the case 221. The depth at which the seating portion 2221 is recessed from the front of the case 221 may be equal to or longer than the length by which the connector body 2131 extends. **In** this case, the direction in which the connector body 2131 extends is the same as the direction in which the connecting protrusion 2132 extends. With such a configuration, in a state in which the connector 213 is coupled to the mounting part 220, no step may occur on the front of the mounting part 220.

The guide portion 222 may include a guide hole 2222. The guide hole 2222 may be provided on the inner side of the seating portion 2221. The guide hole 2222 may be opened vertically from the front side of the case 221 toward the rear side of the case 221.

The guide hole 2222 may allow the connecting protrusion 2132 to pass there through. That is, in a state in which the connecting protrusion 2132 passes through the guide hole 2222, the connecting protrusion 2132 may move in the upper-to-lower direction. As the connecting protrusion 2132 passes through the guide hole 2222, the connecting protrusion 2132 may connect the connector body 2131 and the hinge body 2141.

The mounting part 220 may include a fixing portion 223. The fixing portion 223 may be provided on the guide portion 222. The fixing portion 223 may fix the connector 213 to the fixing portion 223. That is, the connector 213 may move up and down by being guided by the guide portion 222 to, or may be fixed to the fixing portion 223 by the fixing portion 223.

According to the present disclosure, the connector 213, while placed on the fixing portion 223, may be rotatable on the fixing portion 223. As the connector 213 rotates, the connector 213 may be fixed to the fixing portion 223 or released from the fixing portion 223. That is, the connector 213 may be fixed to the fixing portion 223 or released from the fixing portion 223 by rotating on the fixing portion 223. This will be described in detail below.

The fixing portions 223 may be provided in plural. While the mounting part 220 is mounted on the display 100, the plurality of fixing portions 223 may be arranged along the upper-to-lower direction in which the guide portion 222 extends. For example, the fixing portion 223 may include a first fixing portion 2231, a second fixing portion 2232, and a third fixing portion 2233. For example, while the mounting part 220 is mounted on the display 100, the first fixing portion 2231 may be provided on the upper end of the guide portion 222. For example, while the mounting part 220 is mounted on the display 100, the second fixing portion 2232 may be provided on the lower end of the guide portion 222. For example, while the mounting part 220 is mounted on the display 100, the third fixing portion 2233 may be provided on the center of the guide portion 222. Although the fixing portion 223 is illustrated as three fixing portions in the drawings, the number of fixing portions 223 is not limited thereto. In addition, the first fixing portion 2231, the second fixing portion 2232, and the third fixing portion 2233 do not limit the configurations by the ordinal numbers "first," "second," and "third."

The mounting part 220 may include a first magnetic body 224. The first magnetic body 224 may be accommodated inside the case 221. Through the magnetic force of the first magnetic body 224, the mounting part 220 may be more stably mounted on the display 100. For example, the first magnetic body 224 may include a magnet. This will be described in detail below.

The first magnetic body 224 may be arranged between the guide portion 222 and the second hook 228 described below. However, the position of the first magnetic body 224 is not limited thereto. For example, the first magnetic body 224 may be arranged below the guide portion 222. In addition, the first magnetic body 224 may be provided in plural. For example, some of the plurality of first magnetic bodies 224 may be arranged between the guide portion 222 and the second hook 228. For example, some of the plurality of first magnetic bodies 224 may be arranged below the guide portion 222. For example, some of the plurality of first magnetic bodies 224 may be arranged on both sides of the guide portion 222.

The mounting part 220 may include a first hook 225. The first hook 225 may be arranged at one end of the mounting part 220. Specifically, while the mounting part 220 is mounted on the display 100, the first hook 225 may be provided at the lower end of the mounting part 220. Through the first hook 225, the mounting part 220 may be more stably mounted on the display 100. This will be described in detail below.

The mounting part 220 may include a second hook 228. The second hook 228 may be provided at the other end of the mounting part 220. Specifically, while the mounting part 220 is mounted on the display 100, the second hook 228 may be provided at the upper end of the mounting part 220. Through the second hook 228, the mounting part 220 may be more stably mounted on the display 100. This will be described in detail below.

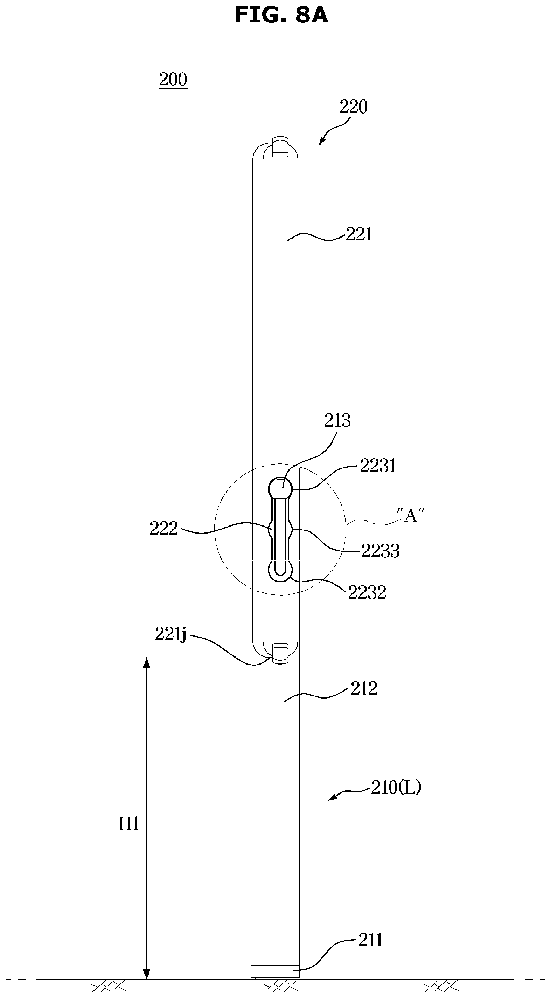

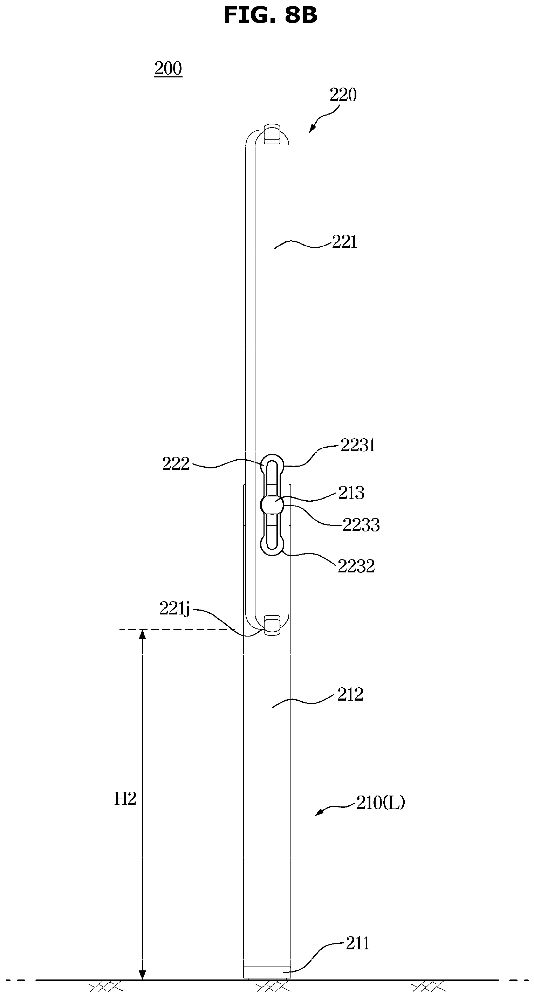

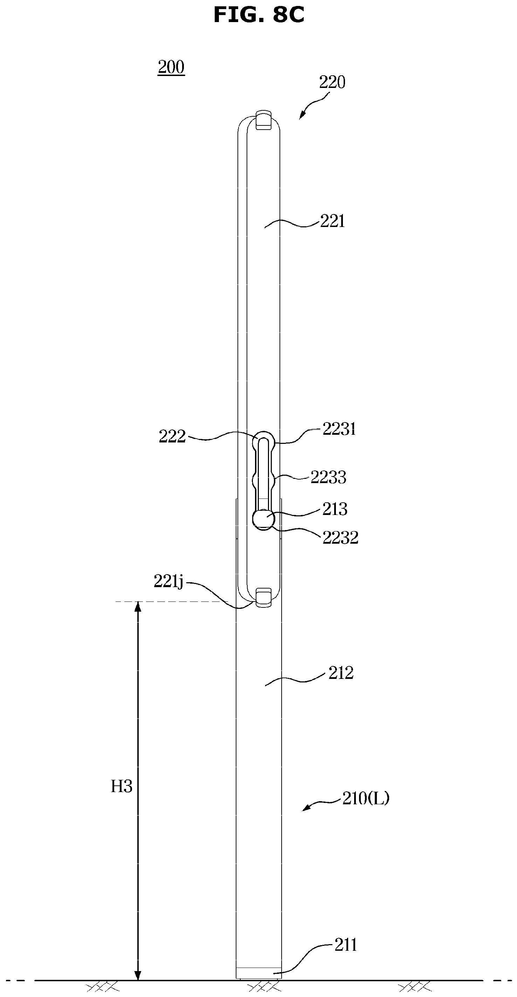

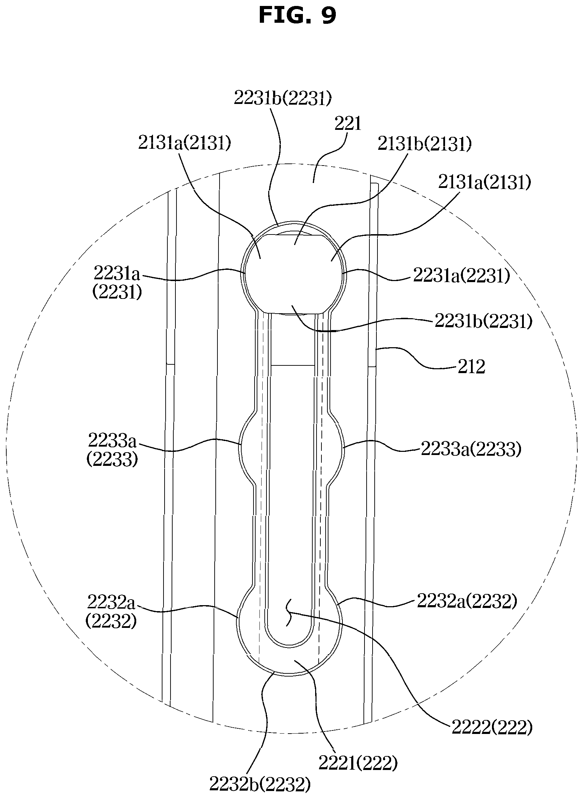

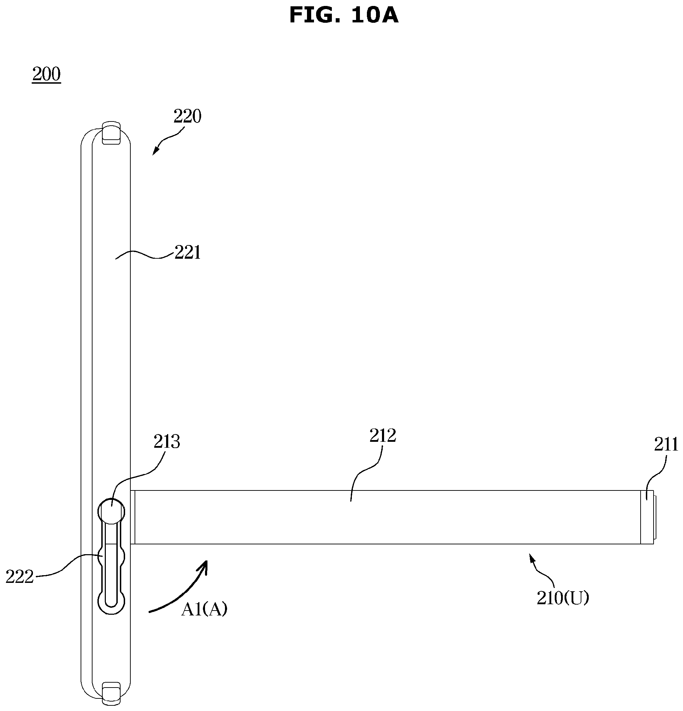

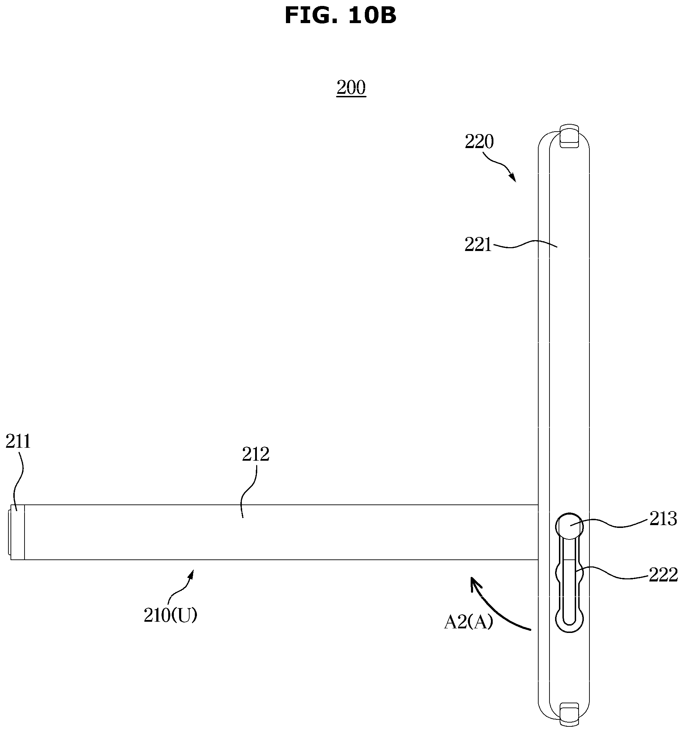

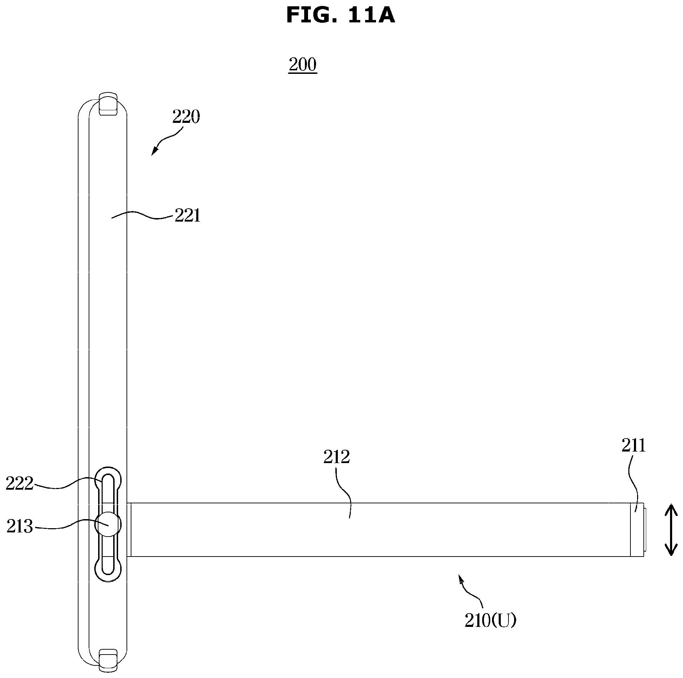

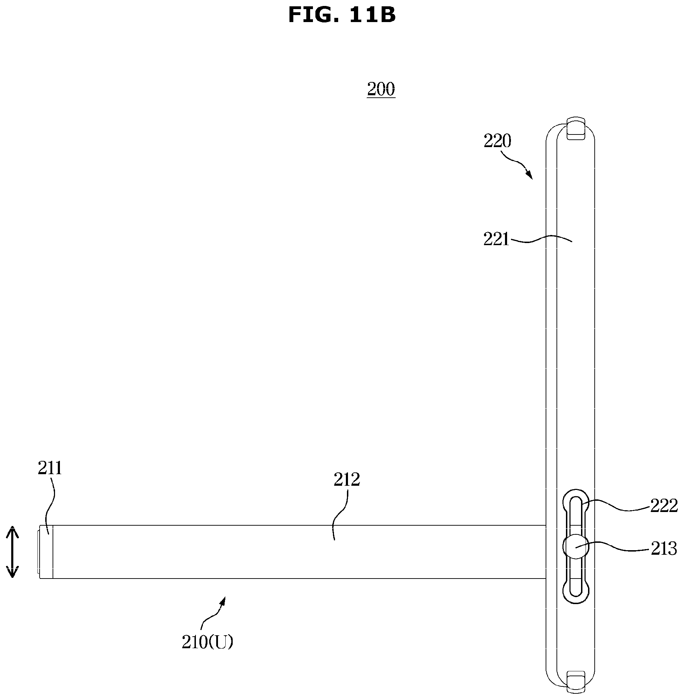

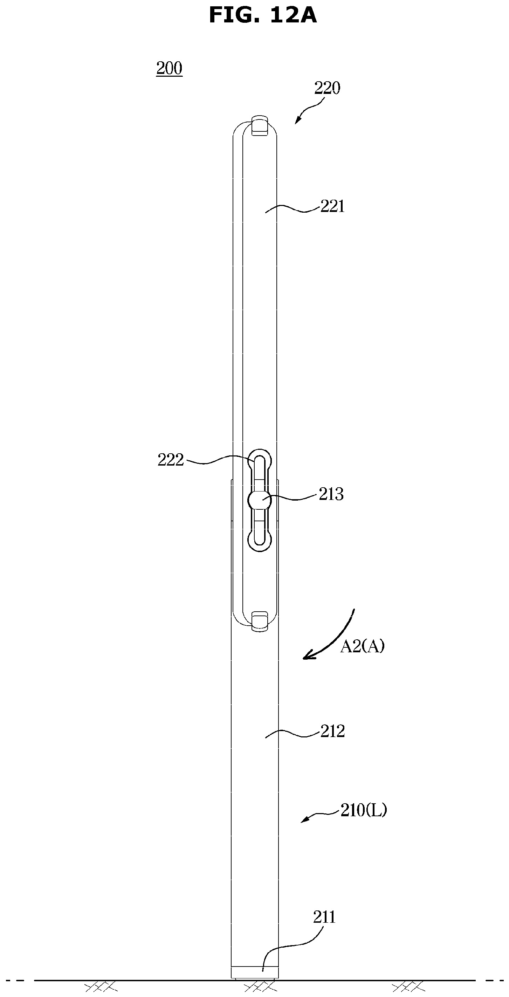

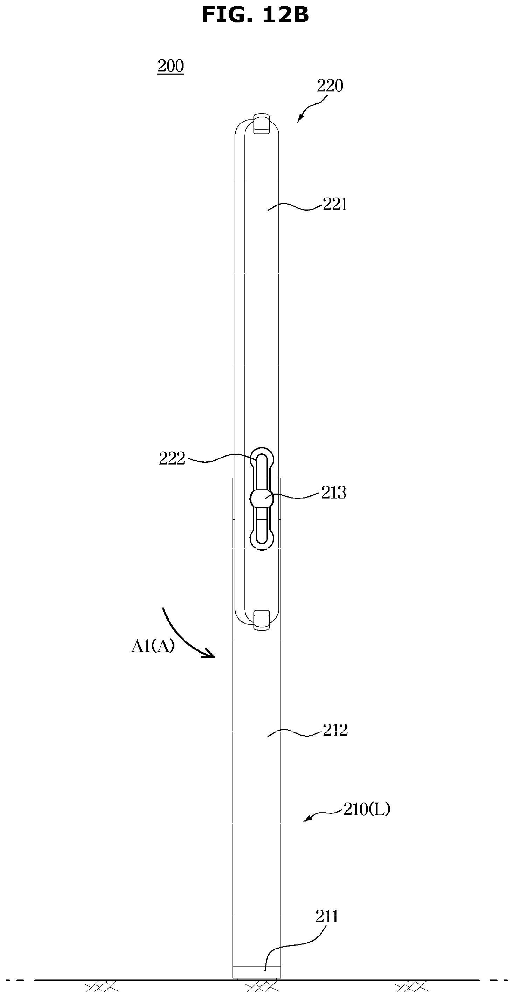

FIG. 8A is a front view of a stand according to one or more embodiments. FIG. 8B is a front view of a stand according to one or more embodiments. FIG. 8C is a front view of a stand according to one or more embodiments. FIG. 9 is an enlarged view illustrating portion A in the stand shown in FIG. 8A. FIG. 10A is a view illustrating the stand shown in FIG. 8A, with a supporting part rotated counterclockwise. FIG. 10B is a view illustrating the stand shown in FIG. 8A, with a supporting part rotated clockwise. FIG. 11A is a view illustrating the stand shown in FIG. 10A, with a supporting part moved downward. FIG. 11B is a view illustrating the stand shown in FIG. 10B, with a supporting part moved downward. FIG. 12A is a view illustrating the stand shown in FIG. 11A, with a supporting part rotated clockwise. FIG. 12B is a view illustrating the stand shown in FIG. 11A, with a supporting part rotated counterclockwise.

Referring to FIGS. 8A to 12B, the supporting part 210 may be placed in a locking position L or an unlocking position U. Specifically, the locking position L may be a position in which the movement of the supporting part 210 relative to the mounting part 220 is restricted. The unlocking position U may be a position in which the movement of the supporting part 210 relative to the mounting part 220 is allowed.

In a state in which the connector 213 is fixed to the fixing portion 223, the supporting part 210 may be in the locking position L. **In** other words, a state in which the supporting part 210 is in the locking position L may be a state in which the fixing portion 223 fixes the connector 213 to a fixed position such that that the supporting part 210 cannot move in the upper-lower direction. **In** a state in which the connector 213 is released from the fixing portion 223, the supporting part 210 may be in the unlocking position U. **In** other words, a state in which the supporting part 210 is in the unlocking position U may be a state in which the fixing portion 223 does not fix the connector 213 such that the supporting part can move in the upper-lower direction.

As described above, the connector 213 may rotate on the fixing portion 223. When the connector 213 rotates on the fixing portion 223, the connector 213 may rotate together with other components of the supporting part 210. That is, the rotation of the connector 213 may correspond to the rotation of the supporting part 210.

As described above, as the connector 213 rotates on the fixing portion 223, the connector 213 may be fixed to the fixing portion 223 or released from the fixing portion 223. **In** other words, as the connector 213 rotates on the fixing portion 223, the supporting part 210 may be disposed at the locking position L or the unlocking position **U. In** other words, as the supporting part 210 rotates, the supporting part 210 may be disposed at the locking position L or the unlocking position U.

The supporting part 210 may be rotatable to the locking position L or the unlocking position U. Specifically, in a state in which the connector 213 is disposed on the fixing portion 223, the supporting part 210 may be rotatable to the locking position L or the unlocking position U. For example, the supporting part 210 having been disposed at the locking position L may be positioned at the unlocking position U after rotation. For example, the supporting part 210 having been disposed at the unlocking position U may be positioned at the locking position L after rotation.

The supporting part 210 may rotate about the central axis of the connecting protrusion 2132. The direction in which the supporting part 210 rotates about the central axis of the connecting protrusion 2132 may be defined as a first direction A. The first direction A may include a first rotation direction A1 in which the supporting part 210 rotates counterclockwise, with reference to FIGS. 8A to 12B. The first direction A may include a second rotation direction A2 in which the supporting part 210 rotates clockwise, with reference to FIGS. 8A to 12B. The first direction A may be a rotation direction about a front-rear axis in the front-rear direction of the display apparatus.

Hereinafter, the locking position L and the unlocking position U will be described first. Then, a method of fixing or releasing the connector 213 to or from the fixing portion 223 will be described.

In the following description, the locking position L and the unlocking position U are defined and described through three fixing portions 2231, 2232, and 2233, but there is no limitation on the number of fixing portions 223, as well as the number of locking positions L and unlocking positions U.

Referring to FIGS. 8A to 8C, the locking position L may be defined as the position of the supporting part 210 when the connector 213 is fixed to the fixing portion 223. Referring to FIG. 8A, the locking position L may include a position of the supporting part 210 when the connector 213 is fixed to the first fixing portion 2231. Referring to FIG. 8B, the locking position L may include a position of the supporting part 210 when the connector 213 is fixed to the second fixing portion 2232. Referring to FIG. 8C, the locking position L may include a position of the supporting part 210 when the connector 213 is fixed to the third fixing portion 2233.

Referring to FIG. 8A, when the connector 213 is fixed to the first fixing portion 2231, the mounting part 220 may be arranged at a first height H1. That is, when the supporting part 210 is at the locking position L, the first fixing portion 2231 may be provided to fix the mounting part 220 at the first height H1. In this case, the first height H1 may be a distance from the floor surface to a bottom surface 221j of the case 221.

Referring to FIG. 8B, when the connector 213 is fixed to the second fixing portion 2232, the mounting part 220 may be arranged at the second height H2. That is, when the supporting part 210 is in the locking position L, the second fixing portion 2232 may be provided to fix the mounting part 220 at the second height H2. The second height H2 may be different from the first height H1. Specifically, the second height H2 may be larger than the first height H1. In this case, the second height H2 may be the distance from the floor surface to the bottom surface 221j of the case 221.

Referring to FIG. 8C, when the connector 213 is fixed to the third fixing portion 2233, the mounting part 220 may be arranged at the third height H3. That is, when the supporting part 210 is in the locking position L, the third fixing portion 2233 may be provided to fix the mounting part 220 at the third height H3. The third height H3 may be different from the first height H1 and the second height H2. Specifically, the third height H3 may be larger than the first height H1 and larger than the second height H2. In this case, the third height H3 may be the distance from the floor surface to the bottom surface 221j of the case 221.

Referring to FIGS. 8A to 8C, when the connector 213 is fixed to the fixing portion 223, the supporting part 210 may be arranged on the lower side of the mounting part 220. In other words, while the connector 213 is fixed to the fixing portion 223, the direction in which the case 221 extends may be parallel to the direction in which the leg 212 extends. In other words, while the connector 213 is fixed to the fixing portion 223, the direction in which the guide portion 222 extends may be parallel to the direction in which the leg 212 extends. That is, the supporting part 210 may be arranged on the floor surface. Specifically, the supporting part 210 may be arranged on the floor surface to support the display 100.

Referring to FIGS. 10A and 10B, the unlocking position U may be defined as the position of the supporting part 210 when the connector 213 is released from being fixed to the fixing portion 223, and provided on the fixing portion 223. In other words, the unlocking position U may be defined as the position of the supporting part 210 when the connector 213 is disposed on the fixing portion 223 and the fixation of the connector 213 to the fixing portion 223 is released.

The unlocking position U may include the position of the supporting part 210 when the connector 213 is positioned above the first fixing portion 2231 and the fixation with the first fixing portion 2231 is released. The unlocking position U may include the position of the supporting part 210 when the connector 213 is positioned above the second fixing portion 2232 and the fixation with the second fixing portion 2232 is released. The unlocking position U may include the position of the supporting part 210 when the connector 213 is positioned above the third fixing portion 2233 and the fixation with the third fixing portion 2233 is released. Although FIG. 10A illustrates only the case in which the connector 213 is positioned above the first fixing portion 2231 and the fixation with the first fixing portion 2231 is released, the unlocking position U is not limited thereto.

Referring to FIGS. 8A and 10A, the supporting part 210 having been disposed at the locking position L may be shifted to the unlocking position U by rotating in the first rotational direction A1. In the drawing, only the case in which the connector 213 is disposed on the first fixing portion 2231 is illustrated, but the present disclosure is not limited thereto. For example, even when the connector 213 is disposed on the second fixing portion 2232 or the third fixing portion 2233, the supporting part 210 having been disposed at the locking position L may be shifted to the unlocking position U by rotating in the first rotational direction A1.

Referring to FIG. 8A and FIG. 10A, when the supporting part 210 rotates in the first rotational direction A1, the fixation of the connector 213 with the fixing portion 223 is released on the fixing portion 223, in which case the supporting part 210 may be arranged on the right side of the mounting part 220 with reference to FIG. 10A. In other words, in a state in which the fixation of the connector 213 with the fixing portion 223 is released, the direction in which the case 221 extends may be perpendicular to the direction in which the leg 212 extends. In other words, in a state in which the fixation of the connector 213 with the fixing portion 223 is released, the direction in which the guide portion 222 extends may be perpendicular to the direction in which the leg 212 extends. That is, the supporting part 210 may be arranged spaced apart from the floor surface.

Referring to FIGS. 8A and 10B, the supporting part 210 having been disposed at the locking position L may be shifted to the unlocking position U by rotating in the second rotational direction A2. In the drawings, only the case in which the connector 213 is disposed on the first fixing portion 2231 is illustrated, but the present disclosure is not limited thereto. For example, even when the connector 213 is disposed on the second fixing portion 2232 or the third fixing portion 2233, the supporting part 210 having been disposed at the locking position L may be shifted to the unlocking position U by rotating in the second rotational direction A2.

Referring to FIGS. 8A and 10B, when the supporting part 210 rotates in the second rotational direction A2, the fixation of the connector 213 with the fixing portion 223 is released on the fixing portion 223, in which case the supporting part 210 may be arranged on the left side of the mounting part 220 with reference to FIG. 10B. In other words, in a state in which the fixation of the connector 213 with the fixing portion 223 is released, the direction in which the case 221 extends may be perpendicular to the direction in which the leg 212 extends. In other words, in a state in which the fixation of the connector 213with the fixing portion 223 is released, the direction in which the guide portion 222 extends may be perpendicular to the direction in which the leg 212 extends. That is, the supporting part 210 may be arranged spaced apart from the floor surface.

Referring to FIGS. 11A and 11B, the supporting part 210 disposed at the unlocking position U may move up and down. The supporting part 210 may move upward or downward. In other words, the supporting part 210 may move between different unlocking positions U. In FIGS. 11A and 11B, only the supporting part 210 is illustrated as moving downward, but as described above, the supporting part 210 may move in both the up and down directions.

Referring to FIGS. 11A and 12A, the supporting part 210 having been disposed at the unlocking position U may be shifted to the locking position L by rotating in the second rotational direction A2. In other words, the supporting part 210 having been disposed on the right side of the mounting part 220 with reference to FIG. 12a may be disposed on the lower side of the mounting part 220 by rotating in the second rotation direction A2. That is, the supporting part 210 may be disposed on the floor surface again. Specifically, the supporting part 210 may be disposed on the floor surface again to support the display 100. In the drawing, only the case in which the connector 213 is disposed on the third fixing portion 2233 is illustrated, but the present disclosure is not limited thereto. For example, even when the connector 213 is disposed on the first fixing portion 2231 or the second fixing portion 2232, the supporting part 210 having been disposed on the unlocking position U may be shifted to the locking position L by rotating in the second rotation direction A2.

Referring to FIGS. 11B and 12B, the supporting part 210 having been disposed at the unlocking position U may be shifted to the locking position L by rotating in the first rotational direction A1. In other words, the supporting part 210 having been disposed on the left side of the mounting part 220 with respect to FIG. 12B may be disposed on the lower side of the mounting part 220 by rotating in the first rotational direction A1. That is, the supporting part 210 may be disposed on the floor surface again. Specifically, the supporting part 210 may be disposed on the floor surface again to support the display 100. In the drawings, only the case in which the connector 213 is disposed on the third fixing portion 2233 is illustrated, but the present disclosure is not limited thereto. For example, even when the connector 213 is disposed on the first fixing portion 2231 or the second fixing portion 2232, the supporting part 210 having been disposed on the unlocking position U may be shifted to the locking position L by rotating in the first rotational direction A1.

Hereinafter, a method by which the connector 213 is fixed to or released from the fixing portion 223 will be described in detail with reference to FIGS. 7 to 12B.

As described above, the connector 213 may be fixed to or released from the fixing portion 223 by rotating on the fixing portion 223. In this case, the direction in which the connector 213 rotates may be the direction of rotation about the central axis of the connecting protrusion 2132. In other words, the direction in which the connector 213 rotates may be the same as the direction in which the supporting part 210 rotates about the central axis of the connecting protrusion 2132. That is, the direction in which the connector 213 rotates may be the first direction A. For example, when the supporting part 210 rotates in the first rotational direction A1, the connector 213 may rotate in the first rotational direction A1. For example, when the supporting part 210 rotates in the second rotational direction A2, the connector 213 may rotate in the second rotational direction A2.

The connector 213 may include a convex portion 2131a. The convex portion 2131a may be provided on the edge of the connector body 2131. The convex portion 2131a may be provided in a shape that is convex outward of the connector body 2131. The convex portion 2131a may be provided such that the center of the convex portion 2131a protrudes the most.

The convex portion 2131a may be provided in plural. For example, the convex portions 2131a may be provided on both sides of the connector 213 with reference to FIG. 7.

The connector 213 may include a flat portion 2131b. The flat portion 2131b may be provided on the edge of the connector body 2131. Specifically, the flat portion 2131b may be provided on one side of the convex portion 2131a. The flat portion 2131b may be provided in a flat shape. With such a configuration, the distance from the center of the connector body 2131 to the most protruding center of the convex portion 2131a may be longer than the distance from the center of the connector body 2131 to the center of the flat portion 2131b.

The flat portion 2131b may be provided in plural. For example, the flat portions 2131b may be provided on the upper and lower sides of the connector body 2131 with reference to FIG. 7. The one pair of flat portions 2131b may be provided parallel to each other. For example, the convex portion 2131a and the flat portion 2131b may be alternately arranged along the edge of the connector body 2131.

The first fixing portion 2231 may include a first concave portion 2231a. The first concave portion 2231a may be provided such that the convex portion 2131a is seated thereon. The first concave portion 2231a may have a shape corresponding to the convex portion 2131a. In other words, the first concave portion 2231a may be recessed outward from the seating portion 2221. The first concave portion 2231a may be arranged on one side of the seating portion 2221 with respect to the upper-to-lower direction in which the guide portion 222 extends.

As described above, at least a portion of the connector body 2131 may be seated on the seating portion 2221. In this case, the convex portion 2131a of the connector body 2131 may be seated on the first concave portion 2231a. By the convex portion 2131a being seated on the first concave portion 2231a, the movement of the connector 213 on the guide portion 222 may be restricted. That is, when the convex portion 2131a is seated on the first concave portion 2231a, the connector 213 may be fixed on the first fixing portion 2231 by the first fixing portion 2231. As a result, with the fixation of the connector 213 to the first fixing portion 2231, the supporting part 210 may be disposed at the locking position L.

The first concave portion 2231a may be provided in plural. For example, the first concave portion 2231a may be arranged on both sides of the seating portion 2221 with respect to the upper-to-lower direction in which the guide portion 222 extends.

The first fixing portion 2231 may include a first rotation guide portion 2231b. The first rotation guide portion 2231b may be provided such that the convex portion 2131a is seated thereon. The first rotation guide portion 2231b may have a shape corresponding to the convex portion 2131a. The first rotation guide portion 2231b may be arranged on the upper end of the seating portion 2221 with respect to the upper-to-lower direction in which the guide portion 222 extends. For example, the first rotation guide portion 2231b may be a part of the seating portion 2221.

The first rotation guide portion 2231b may guide the rotation of the connector body 2131 together with the first concave portion 2231a. Specifically, when the connector 213 is positioned onto the first fixing portion 2231, the first rotation guide portion 2231b and the first concave portion 2231a may guide rotation of the connector body 2131 in the first direction A. For example, the first rotation guide portion 2231b and the first concave portion 2231a may guide rotation of the connector body 2131 in the first rotation direction A1. For example, the first rotation guide portion 2231b and the first concave portion 2231a may guide rotation of the connector body 2131 in the second rotation direction A2. As the connector body 2131 rotates in the first direction A, the connecting protrusion 2132 may rotate together in the first direction A. That is, the connector 213 may rotate in the first direction A.

As described above, in a state in which the convex portion 2131a is seated on the first concave portion 2231a, the connector 213 may be fixed on the first fixing portion 2231 by the first fixing portion 2231. **In** this case, the connector 213 may be rotatable in the first direction A. As the connector 213 rotates in the first direction A, the convex portion 2131a may be seated on the seating portion 2221. That is, the entirety of the connector body 2131 may be seated on the seating portion 2221. **In** other words, the fixation of the connector 213 with the first fixing portion 2231 may be released. As a result, with the release of the connector 213 from the first fixing portion 2231, the supporting part 210 originally disposed at the locking position L may be disposed at the unlocking position U.

The connector body 2131 of the supporting part 210 disposed at the unlocking position U may be entirely seated on the seating portion 2221. **In** this case, the convex portion 2131a may be seated on the first rotation guide portion 2231b. The connector body 2131 may be guided by the first rotation guide portion 2231b and the first concave portion 2231a to rotate in the first direction A. As the connector body 2131 rotates, the convex portion 2131a may be seated on the first concave portion 2231a. **In** other words, the connector 213 may be fixed on the first fixing portion 2231. As a result, with the fixation of the connector 213 to the first fixing portion 2231, the supporting part 210 originally disposed in the unlocking position U may be disposed in the locking position L.

In a state in which the connector 213 is disposed on the first fixing portion 2231, a rotation of the connector 213 in the first direction A may cause the supporting part 210 to be disposed in the locking position L or the unlocking position U. In other words, in a state in which the connector 213 is disposed on the first fixing portion 2231, a rotation of the supporting part 210 in the first direction A may cause the supporting part 210 to be disposed in the locking position L or the unlocking position U.

The second fixing portion 2232 may include a second concave portion 2232a. The second concave portion 2232a may be provided such that the convex portion 2131a is seated thereon. The second concave portion 2232a may have a shape corresponding to the convex portion 2131a. In other words, the second concave portion 2232a may be recessed outward from the seating portion 2221. The second concave portion 2232a may be arranged on one side of the seating portion 2221 with respect to the upper-to-lower direction in which the guide portion 222 extends.

As described above, at least a portion of the connector body 2131 may be seated on the seating portion 2221. In this case, the convex portion 2131a of the connector body 2131 may be seated on the second concave portion 2232a. By the convex portion 2131a being seated on the second concave portion 2232a, the movement of the connector 213 on the guide portion 222 may be restricted. That is, when the convex portion 2131a is seated on the second concave portion 2232a, the connector 213 may be fixed on the second fixing portion 2232 by the second fixing portion 2232. As a result, with the fixation of the connector 213 to the second fixing portion 2232, the supporting part 210 may be disposed at the locking position L.

The second concave portion 2232a may be provided in plural. For example, the second concave portion 2232a may be arranged on both sides of the seating portion 2221 with respect to the upper-to-lower direction in which the guide portion 222 extends.

The second fixing portion 2232 may include a second rotation guide portion 2232b. The second rotation guide portion 2232b may be provided such that the convex portion 2131a is seated thereon. The second rotation guide portion 2232b may have a shape corresponding to the convex portion 2131a. The second rotation guide portion 2232b may be arranged on the lower end of the seating portion 2221 with respect to the upper-to-lower direction in which the guide portion 222 extends. For example, the second rotation guide portion 2232b may be a part of the seating portion 2221.

The second rotation guide portion 2232b may guide the rotation of the connector body 2131 together with the second concave portion 2232a. Specifically, when the connector 213 is positioned onto the second fixing portion 2232, the second rotation guide portion 2232b and the second concave portion 2232a may guide rotation of the connector body 2131 in the first direction A. For example, the second rotation guide portion 2232b and the second concave portion 2232a may guide rotation of the connector body 2131 in the first rotation direction A1. For example, the second rotation guide portion 2232b and the second concave portion 2232a may guide rotation of the connector body 2131 in the second rotation direction A2. As the connector body 2131 rotates in the first direction A, the connecting protrusion 2132 may rotate together in the first direction A. That is, the connector 213 may rotate in the first direction A.

As described above, in a state in which the convex portion 2131a is seated on the second concave portion 2232a, the connector 213 may be fixed on the second fixing portion 2232 by the second fixing portion 2232. In this case, the connector 213 may rotate in the first direction A. As the connector 213 rotates in the first direction A, the convex portion 2131a may be seated on the seating portion 2221. That is, the entirety of the connector body 2131 may be seated on the seating portion 2221. In other words, the fixation of the connector 213 with the second fixing portion 2232 may be released. As a result, with the fixation of the connector 213 to the second fixing portion 2232, the supporting part 210 originally disposed at the locking position L may be disposed at the unlocking position U.

The connector body 2131 of the supporting part 210 disposed at the unlocking position U may be entirely seated on the seating portion 2221. In this case, the convex portion 2131a may be seated on the second rotation guide portion 2232b. The connector body 2131 may be guided by the second rotation guide portion 2232b and the second concave portion 2232a to rotate in the first direction A. As the connector body 2131 rotates, the convex portion 2131a may be seated on the second concave portion 2232a. In other words, the connector 213 may be fixed on the second fixing portion 2232. As a result, with the fixation of the connector 213 to the second fixing portion 2232, the supporting part 210 originally disposed in the unlocking position U may be disposed in the locking position L.

In a state in which the connector 213 is disposed on the second fixing portion 2232, a rotation of the connector 213 in the first direction A may cause the supporting part 210 to be disposed in the locking position L or the unlocking position U. In other words, in a state in which the connector 213 is disposed on the second fixing portion 2232, a rotation of the supporting part 210 may cause the supporting part 210 to be disposed in the locking position L or the unlocking position U.

The third fixing portion 2233 may include a third concave portion 2233a. The third concave portion 2233a may be provided such that the convex portion 2131a is seated thereon. The third concave portion 2233a may have a shape corresponding to the convex portion 2131a. In other words, the third concave portion 2233a may be recessed outward from the seating portion 2221. The third concave portion 2233a may be arranged on one side of the seating portion 2221 with respect to the upper-to-lower direction in which the guide portion 222 extends.

As described above, at least a portion of the connector body 2131 may be seated on the seating portion 2221. In this case, the convex portion 2131a of the connector body 2131 may be seated on the third concave portion 2233a. By the convex portion 2131a being seated on the third concave portion 2233a, the movement of the connector 213 on the guide portion 222 may be restricted. That is, when the convex portion 2131a is seated on the third concave portion 2233a, the connector 213 may be fixed on the third fixing portion 2233 by the third fixing portion 2233. As a result, with the fixation of the connector 213 to the third fixing portion 2233, the supporting part 210 may be disposed at the locking position L.

The third concave portion 2233a may be provided in plural. For example, the third concave portion 2233a may be arranged on both sides of the seating portion 2221 with respect to the upper-to-lower direction in which the guide portion 222 extends.

The third concave portion 2233a may guide the rotation of the connector body 2131. Specifically, when the connector 213 is positioned onto the third fixing portion 2233, the third concave portion 2233a may guide rotation of the connector body 2131 in the first direction A. For example, the third concave portion 2233a may guide rotation of the connector body 2131 in the first rotation direction A1. For example, the third concave portion 2233a may guide rotation of the connector body 2131 in the second rotation direction A2.

As described above, in a state in which the convex portion 2131a is seated on the third concave portion 2233a, the connector 213 may be fixed on the third fixing portion 2233 by the third fixing portion 2233. In this case, the connector 213 may rotate in the first direction A. As the connector 213 rotates, the convex portion 2131a may be seated on the seating portion 2221. That is, the entirety of the connector body 2131 may be seated on the seating portion 2221. In other words, the fixation of the connector 213 with the third fixing portion 2233 may be released. As a result, with the release of the connector 213 from the third fixing portion 2233, the supporting part 210 originally disposed at the locking position L may be disposed at the unlocking position U.

The connector body 2131 of the supporting part 210 disposed at the unlocking position U may be entirely seated on the seating portion 2221. The connector body 2131 may be guided by the third concave portion 2233a to rotate in the first direction A. As the connector body 2131 rotates, the convex portion 2131a may be seated on the third concave portion 2233a. **In** other words, the connector 213 may be fixed on the third fixing portion 2233. As a result, with the fixation of the connector 213 to the third fixing portion 2233, the supporting part 210 originally disposed in the unlocking position U may be disposed in the locking position L.

In a state in which the connector 213 is disposed on the third fixing portion 2233, a rotation of the connector 213 in the first direction A may cause the supporting part 210 to be disposed in the locking position L or the unlocking position U. **In** other words, in a state in which the connector 213 is disposed on the third fixing portion 2233, a rotation of the supporting part 210 may cause the supporting part 210 to be disposed in the locking position L or the unlocking position U.

As described above, the connector 213 may be movably coupled to the guide portion 222. For example, when the supporting part 210 is in the unlocking position U, the connector 213 may be guided by the guide portion 222 to move between the first fixing portion 2231 and the second fixing portion 2232. For example, when the supporting part 210 is in the unlocking position U, the connector 213 may be guided by the guide portion 222 to move between the first fixing portion 2231 and the third fixing portion 2233. For example, when the supporting part 210 is in the unlocking position U, the connector 213 may be guided by the guide portion 222 to move between the second fixing portion 2232 and the third fixing portion 2233. Since the connector 213 is guided by the guide portion 222 to move in the upper-to-lower direction, the supporting part 210 may be moved in the upper-to-lower direction.

According to the concept of the present disclosure, the spacing between adjacent fixing portions 223 may be approximately constant. In this case, the spacing between adjacent fixing portions 223 is defined as the distance between the centers of each of the adjacent fixing portions 223. For example, the distance between the first fixing portion 2231 and the second fixing portion 2232 may be the same as the distance between the second fixing portion 2232 and the third fixing portion 2233. For example, the distance between adjacent fixing portions 223 may be 15 mm. However, there is no limitation on the distance between adjacent fixing portions 223.

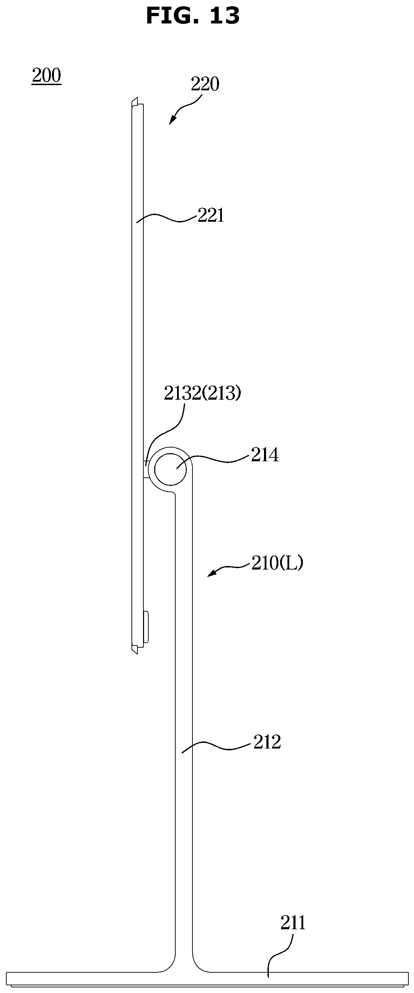

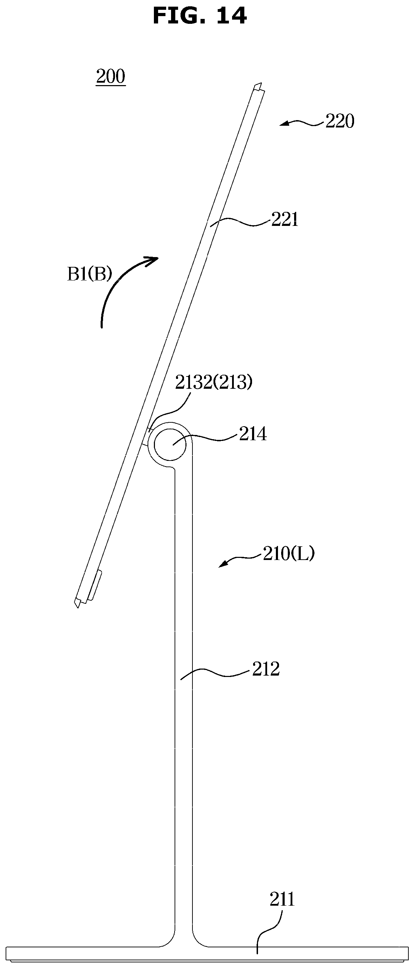

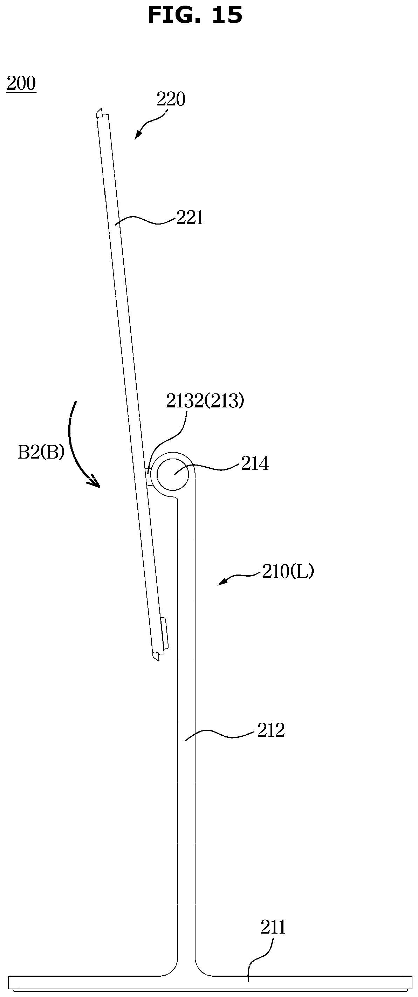

FIG. 13 is a side view of a stand according to one or more embodiments. FIG. 14 is a view illustrating the stand shown in FIG. 13, with a mounting part rotated clockwise. FIG. 15 is a view illustrating the stand shown in FIG. 13, with a mounting part rotated counterclockwise.

Referring to FIGS. 13 to 15, the mounting part 220 may rotate with respect to the leg 212. In addition, as described above, the mounting part 220 may rotate with respect to the leg 212 together with the connector 213 and the hinge body 2141 (see FIGS. 3 to 6). The following description assumes that the mounting part 220 rotates together with the connector 213 and the hinge body 2141, and details of the connector 213 and the hinge body 2141 may be omitted.

The direction in which the mounting part 220 rotates with respect to the leg 212 may be a second direction B different from the first direction A. That is, the mounting part 220 may be rotatable in the second direction B different from the first direction A in which the supporting part 210 rotates.

As described above, the mounting part 220 may rotate about the hinge shaft 2142. That is, the direction in which the mounting part 220 rotates about the hinge shaft 2142 may be defined as the second direction B. In other words, the direction in which the connector 213 rotates about the hinge shaft 2142 may be defined as the second direction B (see FIGS. 3 to 6). In other words, the direction in which the hinge body 2141 rotates about the hinge shaft 2142 may be defined as the second direction B.

The second direction B may include a third rotation direction B1 in which the mounting part 220 rotates clockwise, with reference to FIGS. 13 to 15. The second direction B may include a fourth rotation direction B2 in which the mounting part 220 rotates counterclockwise, with reference to FIGS. 13 to 15. The second direction B may be a rotation direction about a left-right axis in the left-right direction of the display apparatus.

Referring to FIGS. 13 and 14, the mounting part 220 may rotate in the third rotation direction B1. For example, when the mounting part 220 is disposed perpendicular to the base 211 (see FIG. 13), the maximum angle at which the mounting part 220 may rotate in the third rotation direction B1 may be approximately 15 degrees. However, there is no limitation on the maximum angle at which the mounting part 220 may rotate in the third rotation direction B1.

Referring to FIGS. 13 and 15, the mounting part 220 may rotate in the fourth rotation direction B2. For example, when the mounting part 220 is disposed perpendicular to the base 211 (see FIG. 13), the maximum angle at which the mounting part 220 may rotate in the fourth rotation direction B2 may be approximately 10 degrees. However, there is no limitation on the maximum angle at which the mounting part 220 may rotate in the fourth rotation direction B2.

The mounting part 220 may be rotatable in the second direction B when the supporting part 210 is in the locking position L. However, since the mounting part 220 rotates about the hinge shaft 2142, even when the supporting part 210 is not in the locking position L, the mounting part 220 may be rotatable in the second direction B. For example, the mounting part 220 may be rotatable in the second direction B even when the supporting part 210 is in the unlocking position U. In the disclosure, the rotation of the mounting part 220 is described only when the supporting part 210 is in the locking position L, but the mounting part 220 is rotatable as described above even when the supporting part 210 is not in the locking position L.

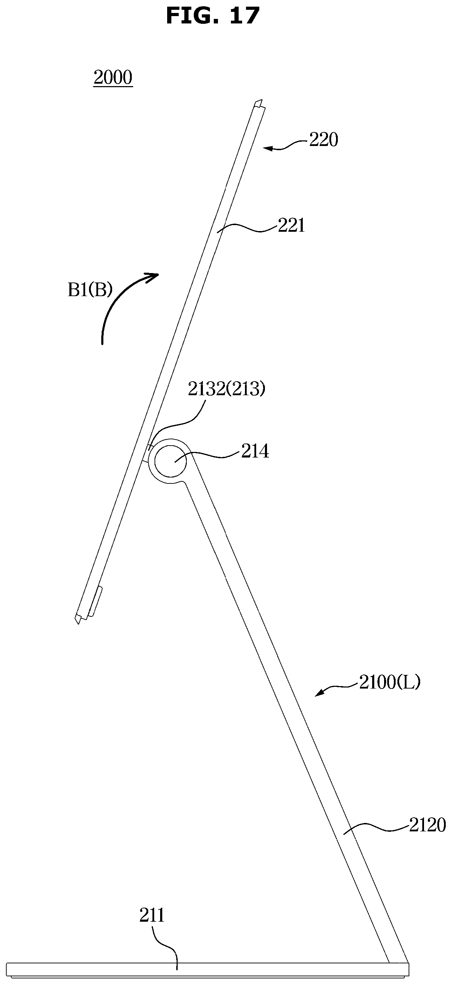

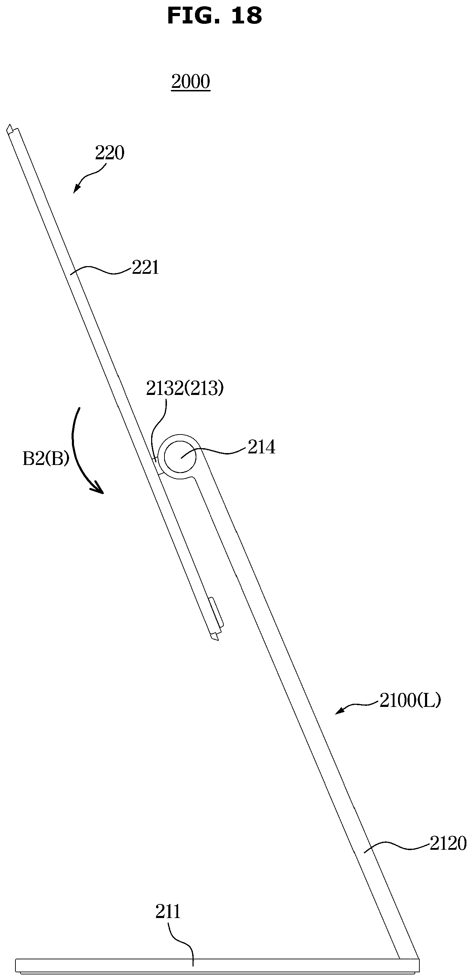

FIG. 16 is a side view of a stand according to one or more embodiments. FIG. 17 is a view illustrating the stand shown in FIG. 16, with a mounting part rotated clockwise. FIG. 18 is a view illustrating the stand shown in FIG. 13, with a mounting part rotated counterclockwise.

Hereinafter, a stand 2000 including a supporting part 2100 different from the supporting part 210 shown in FIGS. 13 to 15 is described with reference to FIGS. 16 to 18. In describing the stand 2000, the same reference numerals may be assigned to components substantially the same as the components of the stand 200 described with reference to FIGS. 1 to 15 and a description thereof will be omitted.

Referring to FIGS. 16 to 18, the supporting part 2100 may include a leg 2120. The leg 2120 may extend from a base 211. Specifically, the leg 2120 may extend upward from the base 211.

The leg 2120 may extend obliquely from the base 211. Specifically, the leg 2120 may extend obliquely from the base 211 such that the upper end of the leg 2120 is disposed forward of the lower end of the leg 2120. For example, the leg 2120 may be extended obliquely from one end of the base 211 that is disposed relatively rearward.

The mounting part 220 may be rotatable with respect to the leg 2120. The direction in which the mounting part 220 rotates with respect to the leg 2120 may be a second direction B. The second direction B may include a third rotation direction B1 in which the mounting part 220 rotates clockwise with reference to FIGS. 16 to 18. The second direction B may include a fourth rotation direction B2 in which the mounting part 220 rotates counterclockwise, with reference to FIGS. 16 to 18.

Referring to FIGS. 16 and 17, the mounting part 220 may rotate in the third rotation direction B1. For example, when the mounting part 220 is disposed perpendicular to the base 211 (see FIG. 16), the maximum angle at which the mounting part 220 may rotate in the third rotation direction B1 may be approximately 15 degrees. However, there is no limitation on the maximum angle at which the mounting part 220 may rotate in the third rotation direction B1.

Referring to FIGS. 16 and 18, the mounting part 220 may rotate in the fourth rotation direction B2. **In** this case, since the leg 2120 is arranged at an angle with respect to the base 211, the mounting part 220 may rotate in the fourth rotation direction B2 within a wider angle range than when the leg 212 is arranged perpendicular to the base 211 (see FIGS. 13 to 15). That is, the maximum angle at which the mounting part 220 may be rotatable in the fourth rotation direction B2 from a position in which the mounting part 220 is arranged vertically with respect to the base 211 (see FIG. 16) may be relatively larger. However, there is no limitation on the maximum angle at which the mounting part 220 may rotate in the fourth rotation direction B2.

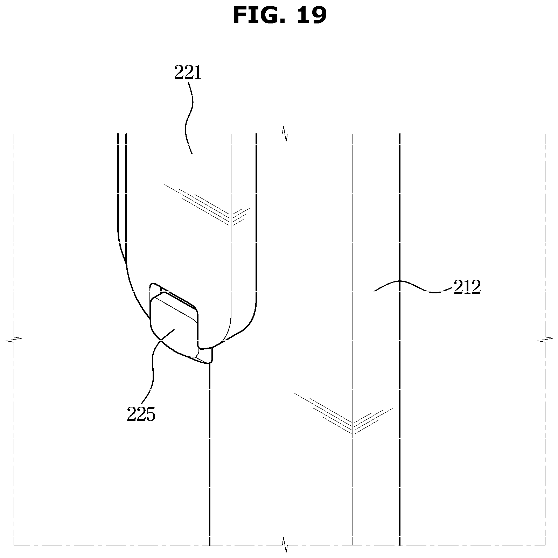

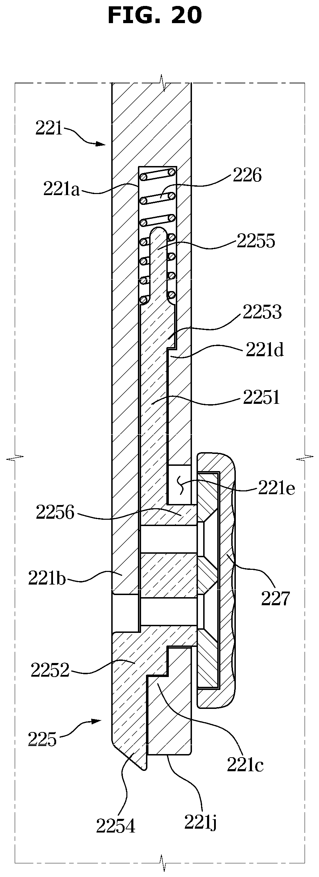

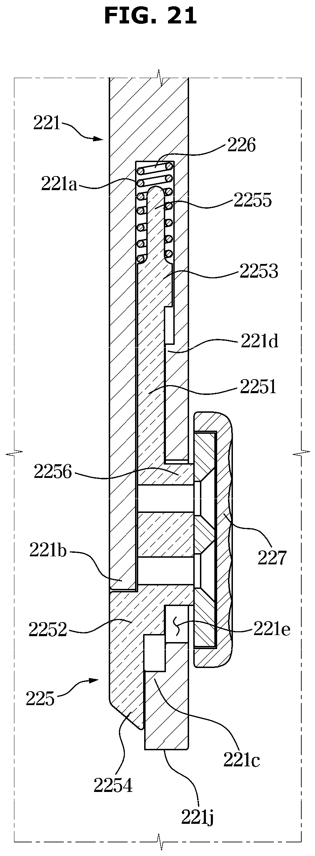

FIG. 19 is an enlarged view of a first hook in a stand according to one or more embodiments. FIG. 20 is a side cross-sectional view of the first hook shown in FIG. 19. FIG. 21 is a side cross-sectional view of the first hook shown in FIG. 20, when moved upward.

Referring to FIGS. 19 to 21, the first hook 225 may be mounted in a first hook mounting groove 221aa provided at the lower end of the case 221. At least a portion of the first hook 225 may be accommodated inside the first hook mounting groove 221a. Specifically, a first hook body 2251, a second stepped portion 2253, and a first protrusion portion 2255, which will be described below, may be accommodated inside the first hook mounting groove 221a.

The first hook 225 may include the first hook body 2251. The first hook body 2251 may be accommodated inside the first hook mounting groove 221a. The first hook body 2251 may extend in the upper-to-lower direction. The length of the first hook body 2251 extending in the upper-to-lower direction may be smaller than the length of the first hook mounting groove 221a extending in the upper-to-lower direction. In other words, the volume of the first hook body 2251 may be smaller than the internal volume of the first hook mounting groove 221a. With such a configuration, the first hook 225 may move in the upper-to-lower direction within a predetermined range while mounted in the first hook mounting groove 221a. Specifically, the first hook 225 may move in the upper-to-lower direction with respect to the case 221 within a predetermined range while mounted in the first hook mounting groove 221a. Hereinafter, the up and down movement of the first hook 225 may assume the up and down movement with respect to the case 221.

The first hook 225 may include a first stepped portion 2252. The first stepped portion 2252 may be provided on the front lower end of the first hook body 2251. The first stepped portion 2252 may be stepped from the first hook body 2251. The first stepped portion 2252 may be provided at the lower end of the first hook mounting groove 221a. That is, the first stepped portion 2252 may be provided at the outer side of the case 221.

The first hook 225 may include a second stepped portion 2253. The second stepped portion 2253 may be provided on the rear upper end of the first hook body 2251. The second stepped portion 2253 may be stepped from the first hook body 2251.

The first hook 225 may include a first inclined portion 2254. The first inclined portion 2254 may be provided on the lower end of the first hook 225. Specifically, the first inclined portion 2254 may be provided on the lower end of the first stepped portion 2252. The first inclined portion 2254 may be angled from the front side of the first stepped portion 2252 to face obliquely forward. In other words, the first inclined portion 2254 may be inclined to form an obtuse angle with the front side of the first stepped portion 2252.

The first hook 225 may include a first protrusion portion 2255. The first protrusion portion 2255 may be provided on the upper end of the first hook 225. Specifically, the first protrusion portion 2255 may be provided on the upper end of the first hook body 2251. The first protrusion portion 2255 may protrude upward from the upper surface of the first hook body 2251.

The mounting part 220 may include a first elastic body 226. The first elastic body 226 may be arranged on the upper end of the first hook 225. Specifically, the first elastic body 226 may be fitted to the first protrusion portion 2255. For example, the first elastic body 226 may include a spring.

The mounting part 220 may include a sliding part 227. The sliding part 227 may be provided on the outer surface of the case 221. Specifically, the sliding part 227 may be provided on the lower rear end of the case 221.

The sliding part 227 may be connected to the first hook 225. Specifically, the first hook 225 may be connected to the sliding part 227 through a connecting portion 2256 provided at the rear lower portion of the first hook body 2251. In this case, the connecting portion 2256 may pass through a connecting hole 221e provided at the rear lower portion of the case 221. In addition, the thickness of the connecting portion 2256 may be thinner than the width of the connecting hole 221e. That is, the connecting portion 2256 may be arranged to be spaced apart from at least one of the upper end or the lower end of the connecting hole 221e. With such a configuration, the sliding part 227 may move up and down with respect to the case 221 together with the first hook 225.

The case 221 may include a first catching portion 221b. The first catching portion 221b may be provided on the front side of the first hook mounting groove 221a. The first catching portion 221b may be provided on the upper side of the first stepped portion 2252 when the first hook 225 is mounted in the first hook mounting groove 221a. With such a configuration, when the first hook 225 moves upward by a predetermined distance, the first stepped portion 2252 is caught on the first catching portion 221b, thereby limiting additional upward movement of the first hook 225.

The case 221 may include a second catching portion 221c. The second catching portion 221c may be provided on the lower side of the first hook mounting groove 221a. The second catching portion 221c may be provided on the lower side of the first hook body 2251 when the first hook 225 is mounted in the first hook mounting groove 221a. With such a configuration, when the first hook 225 moves downward by a predetermined distance, the first hook body 2251 may be caught on the second catching portion 221c, thereby limiting further downward movement of the first hook 225.

The case 221 may include a third catching portion 221d. The third catching portion 221d may be provided on the inner upper portion of the first hook mounting groove 221a. The third catching portion 221d may be provided at the lower side of the second stepped portion 2253 when the first hook 225 is mounted in the first hook mounting groove 221a. With such a configuration, when the first hook 225 moves downward by a predetermined distance, the second stepped portion 2253 may be caught by the third catching portion 221d, thereby limiting further downward movement of the first hook 225. That is, when the first hook 225 moves downward by a predetermined distance, the second catching portion 221c and the third catching portion 221d may be provided to limit further downward movement of the first hook 225.

According to the concept of the present disclosure, when no additional external force is applied to the sliding part 227 or the first hook 225, the sliding part 227 and the first hook 225 may be subjected to downward force due to the own weight and the first elastic body 226. In this case, the first hook 225 may be moved downward, allowing the first hook body 2251 to be seated to the second catching portion 221c, and the second stepped portion 2253 to be seated to the third catching portion 221d (see FIG. 20).

According to the concept of the present disclosure, when the sliding part 227 slides upward and downward, the first hook 225 may be moved upward and downward. For example, when the sliding part 227 is subjected to upward force, the sliding part 227 may be moved upward together with the first hook 225. In this case, the first hook 225 may be moved upward, allowing the first stepped portion 2252 to be seated to the first catching portion 221b. In addition, the first elastic body 226 arranged on the upper end of the first hook 225 may be compressed to press the first hook 225 downward (see FIG. 21). Thereafter, when the force acting on the sliding part 227 is removed, the first hook 225 may be moved downward due to the force of the first elastic body 226 pressing the first hook 225 downward. In this case, the maximum distance that the first hook 225 may move in the upper-to-lower direction may be determined by the distance between the first stepped portion 2252 and the first catching portion 221b, the distance between the first hook body 2251 and the second catching portion 221c, and the distance between the second stepped portion 2253 and the third catching portion 221d.

According to the concept of the present disclosure, the first hook 225 may automatically move upward by the first inclined portion 2254 of the first hook 225 when the mounting part 220 is mounted in a mounting groove 1221 to be described below. This will be described in detail below.

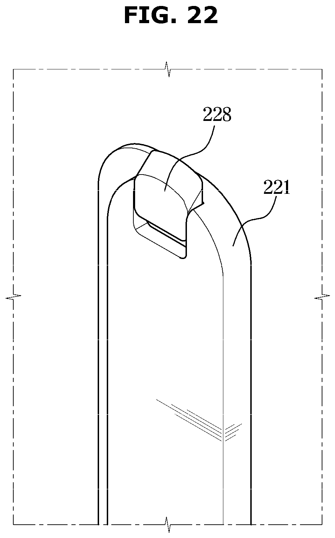

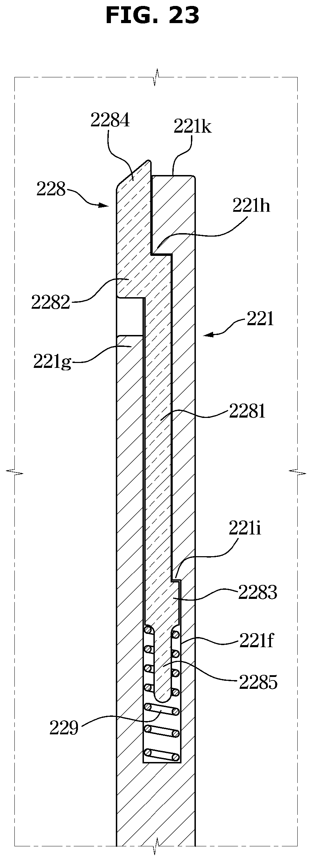

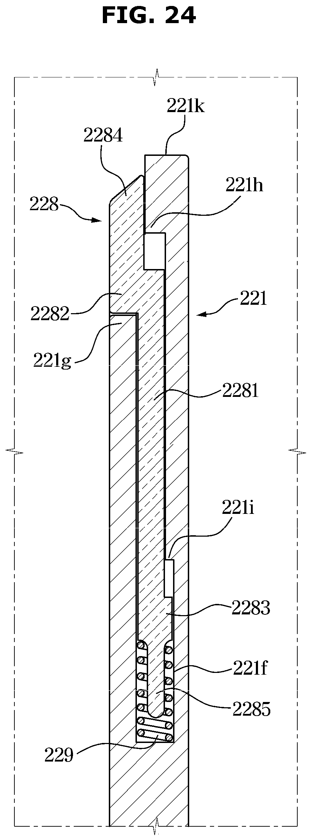

FIG. 22 is an enlarged view of a second hook in a stand according to one or more embodiments. FIG. 23 is a side cross-sectional view of the second hook shown in FIG. 22. FIG. 24 is a side cross-sectional view of the second hook shown in FIG. 23, when moved downward.

Referring to FIGS. 22 to 24, the second hook 228 may be mounted in a second hook mounting groove 221f provided at the upper end of the case 221. At least a portion of the second hook 228 may be accommodated inside the second hook mounting groove 221f. Specifically, the second hook body 2281, the fourth stepped portion 2283, and the second protrusion portion 2285, which will be described below, may be accommodated inside the second hook mounting groove 221f.

The second hook 228 may include a second hook body 2281. The second hook body 2281 may be accommodated inside the second hook mounting groove 221f. The second hook body 2281 may extend in the upper-to-lower direction. The length of the second hook body 2281 extending in the upper-to-lower direction may be smaller than the length of the second hook mounting groove 221f extending in the upper-to-lower direction. In other words, the volume of the second hook body 2281 may be smaller than the internal volume of the second hook mounting groove 221f. With such a configuration, the second hook 228 may move in the upper-to-lower direction within a predetermined range when mounted in the second hook mounting groove 221f. Specifically, the second hook 228 may move in the upper-to-lower direction with respect to the case 221 within a predetermined range when mounted in the second hook mounting groove 221f. Hereinafter, the up and down movement of the second hook 228 may assume the up and down movement with respect to the case 221.

The second hook 228 may include a third stepped portion 2282. The third stepped portion 2282 may be provided at the front upper end of the second hook body 2281. The third stepped portion 2282 may be stepped from the second hook body 2281. The third stepped portion 2282 may be provided at the upper side of the second hook mounting groove 221f. That is, the third stepped portion 2282 may be provided at the outer side of the case 221.

The second hook 228 may include a fourth stepped portion 2283. The fourth stepped portion 2283 may be provided at the rear lower end of the second hook body 2281. The fourth stepped portion 2283 may be stepped from the second hook body 2281.

The second hook 228 may include a second inclined portion 2284. The second inclined portion 2284 may be provided on an upper end of the second hook 228. Specifically, the second inclined portion 2284 may be provided on the upper end of the third stepped portion 2282. The second inclined portion 2284 may be angled from the front side of the third stepped portion 2282 to face obliquely forward. In other words, the second inclined portion 2284 may be inclined to form an obtuse angle with the front side of the third stepped portion 2282.

The second hook 228 may include a second protrusion portion 2285. The second protrusion portion 2285 may be provided on the lower end of the second hook 228. Specifically, the second protrusion portion 2285 may be provided on the lower end of the second hook body 2281. The second protrusion portion 2285 may protrude downward from the lower surface of the second hook body 2281.

The mounting part 220 may include a second elastic body 229. The second elastic body 229 may be arranged at the lower end of the second hook 228. Specifically, the second elastic body 229 may be fitted to the second protrusion portion 2285. For example, the second elastic body 229 may include a spring.

The case 221 may include a fourth catching portion 221g. The fourth catching portion 221g may be provided at the front side of the second hook mounting groove 221f. The fourth catching portion 221g may be provided on the lower side of the third stepped portion 2282 when the second hook 228 is mounted in the second hook mounting groove 221f. With such a configuration, while the second hook 228 moves downward by a predetermined distance, the third stepped portion 2282 may be caught by the fourth catching portion 221g, thereby limiting further downward movement of the second hook 228.

The case 221 may include a fifth catching portion 221h. The fifth catching portion 221h may be provided on the upper side of the second hook mounting groove 221f. The fifth catching portion 221h may be provided on the upper side of the second hook body 2281 when the second hook 228 is mounted on the second hook mounting groove 221f. With such a configuration, when the second hook 228 moves upward by a predetermined distance, the second hook body 2281 is caught by the fifth catching portion 221h, thereby limiting further upward movement of the second hook 228.

The case 221 may include a sixth catching portion 221i. The sixth catching portion 221i may be provided on the inner lower portion of the second hook mounting groove 221f. The sixth catching portion 221i may be provided at the lower side of the fourth stepped portion 2283 when the second hook 228 is mounted in the second hook mounting groove 221f. With such a configuration, when the second hook 228 moves upward by a predetermined distance, the fourth stepped portion 2283 is caught by the sixth catching portion 221i, thereby limiting further upward movement of the second hook 228. That is, when the second hook 228 moves upward by a predetermined distance, the fifth catching portion 221h and the sixth catching portion 221i may be provided to limit further upward movement of the second hook 228.

According to the concept of the present disclosure, when no additional external force is applied to the second hook 228, the second hook 228 may be subject to upward force due to the second elastic body 229. In this case, the second hook 228 may be moved upward, allowing the second hook body 2281 to be seated to the fifth catching portion 221h and the fourth stepped portion 2283 to be seated to the sixth catching portion 221i (see FIG. 23).

According to the concept of the present disclosure, when the second hook 228 is subjected to a downward force, the second hook 228 may move downward. In this case, the second hook 228 may be moved downward, allowing the third stepped portion 2282 to be seated on the fourth catching portion 221g. In addition, the second elastic body 229 arranged on the lower end of the second hook 228 may be compressed to press the second hook 228 upward (see FIG. 24). Thereafter, when the force acting on the second hook 228 is removed, the second hook 228 may be moved upward due to the force of the second elastic body 229 pressing the second hook 228 upward. In this case, the maximum distance that the second hook 228 may move in the upper-to-lower direction may be determined by the distance between the third stepped portion 2282 and the fourth catching portion 221g, the distance between the second hook body 2281 and the fifth catching portion 221h, and the distance between the fourth stepped portion 2283 and the sixth catching portion 221i.

According to the concept of the present disclosure, the second hook 228 may be automatically moved downward by the second inclined portion 2284 of the second hook 228 when the mounting part 220 is mounted in a mounting groove 1221 to be described below. This will be described in detail below.

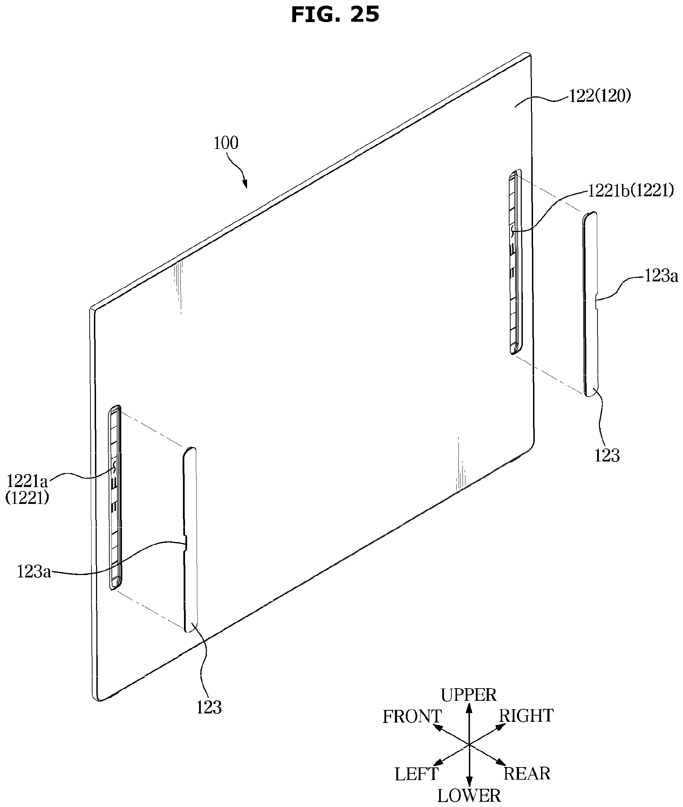

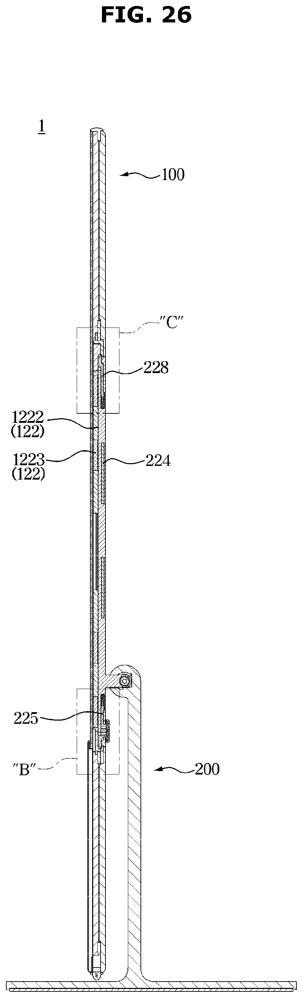

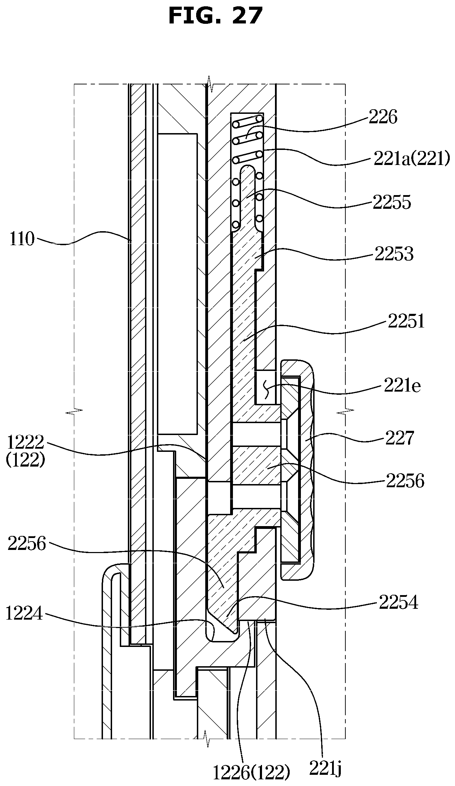

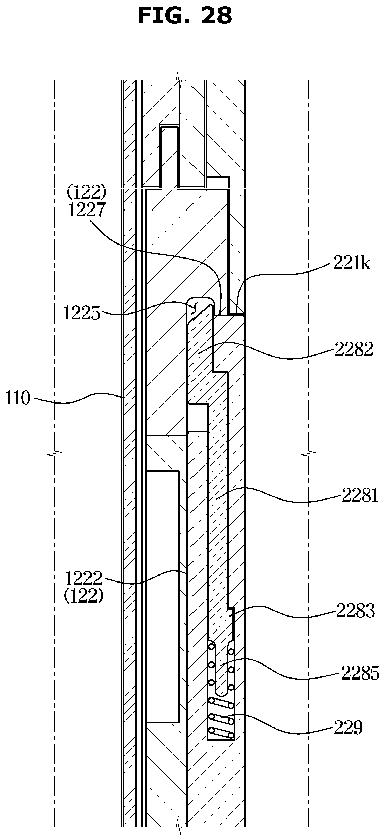

FIG. 25 is a view illustrating some components of a display that are disassembled. FIG. 26 is a side cross-sectional view of a display apparatus according to one or more embodiments. FIG. 27 is an enlarged view of portion B in the display apparatus shown in FIG. 26. FIG. 28 is an enlarged view of portion C in the display apparatus shown in FIG. 26.

Referring to FIGS. 25 to 28, the rear cover 122 may include a mounting groove 1221. The mounting groove 1221 may be provided such that the stand 200 is mounted thereon. Specifically, the mounting groove 1221 may be provided such that the mounting part 220 is mount thereon.

The mounting groove 1221 may be provided on the rear side of the rear cover 122. The mounting groove 1221 may be formed by the rear side of the rear cover 122 being recessed inward. The mounting groove 1221 may be provided in a shape corresponding to the shape of the mounting part 220. For example, the mounting groove 1221 may extend in the upper-to-lower direction.

According to the concept of the present disclosure, the height of the mounting part 220 may vary depending on the fixing portions 223 to which the connector 213 is fixed. In addition, the height of the display 100 may vary depending on the height of the mounting part 220 when the mounting part 220 is mounted in the mounting groove 1221. The height of the display 100 may be the distance from the floor surface to the bottom surface of the display 100.

According to the concept of the present disclosure, the height of the mounting part 220 may be adjusted regardless of whether the mounting part 220 is mounted in the mounting groove 1221. That is, even when the mounting part 220 is mounted in the mounting groove 1221, the height of the mounting part 220 may be adjusted through the rotation of the supporting part 210 in the first direction A and the up and down movement of the supporting part 210. As the height of the mounting part 220 is adjusted, the height of the display 100 may be adjusted.

The mounting groove 1221 may be provided in plural. For example, the mounting grooves 1221 may include a first mounting groove 1221a and a second mounting groove 1221b. The first mounting groove 1221a may be arranged at one end of the rear cover 122. The second mounting groove 1221b may be arranged at the other end of the rear cover 122. For example, the first stand 201 may be mounted in the first mounting groove 1221a, and the second stand 202 may be mounted in the second mounting groove 1221b. Although two mounting grooves 1221 are shown in the drawing, there is no limitation on the number of mounting grooves 1221. For example, the number of mounting grooves 1221 may correspond to the number of stands 200.

The display housing 120 may include a cap 123. The cap 123 may be provided to cover the mounting groove 1221. The cap 123 may be detachably mountable to the rear cover 122. After the cap 123 is detached from the rear cover 122, the stand 200 may be mounted on the mounting groove 1221.

The cap 123 may include a groove portion 123a that allows the cap 123 to be easily separated from the rear cover 122. The groove portion 123a may be provided in the center of the cap 123. While the cap 123 is mounted on the rear cover 122, the user of the display apparatus 1 may easily separate the cap 123 from the rear cover 122 through a gap between the rear cover 122 and the cap 123 formed through the groove portion 123a.

The cap 123 may be provided in plural. For example, the cap 123 may include a first cap 1231 and a second cap 1232. The first cap 1231 may be provided to cover the first mounting groove 1221a. The second cap 1232 may be provided to cover the second mounting groove 1221b. Although two caps 123 are shown in the drawing, there is no limitation on the number of caps 123. For example, the number of caps 123 may correspond to the number of mounting grooves 1221.

The rear cover 122 may include a seating surface 1222 provided to allow the mounting part 220 to be seated thereon. The seating surface 1222 may be provided on the inner side of the mounting groove 1221. The seating surface 1222 may have a shape corresponding to the front of the mounting part 220. For example, the seating surface 1222 may extend in the upper-to-lower direction. With such a configuration, the mounting part 220 may be mounted on the seating surface 1222 when the mounting part 220 is mounted in the mounting groove 1221.

The rear cover 122 may include a second magnetic body 1223. The second magnetic body 1223 may be arranged adjacent to the seating surface 1222. The second magnetic body 1223 may be arranged on the front side of the seating surface 1222. Specifically, when the mounting part 220 is mounted in the mounting groove 1221, the second magnetic body 1223 may be arranged on a side opposite to the mounting part 220 with respect to the seating surface 1222.

According to the concept of the present disclosure, when the mounting part 220 is mounted in the mounting groove 1221, the first magnetic body 224 and the second magnetic body 1223 may be arranged adjacent to each other. In this case, the magnetic forces of each of the first magnetic body 224 and the second magnetic body 1223 may act as attractive forces to each other. Through the action of such attractive force, the mounting part 220 may be more stably mounted in the mounting groove 1221. That is, through the first magnetic body 224 and the second magnetic body 1223, the mounting part 220 may be more stably mounted in the display 100.

The rear cover 122 may include a first hook insertion groove 1224. While the mounting part 220 is mounted in the mounting groove 1221, the first hook insertion groove 1224 may allow at least a portion of the first hook 225 to be inserted thereinto. Specifically, while the mounting part 220 is mounted in the mounting groove 1221, the first inclined portion 2254 of the first hook 225 may be inserted into the first hook insertion groove 1224. With the first inclined portion 2254 being inserted into the first hook insertion groove 1224, the mounting part 220 may be more stably mounted on the display 100.

The first hook insertion groove 1224 may be provided at one end of the mounting groove 1221. Specifically, the first hook insertion groove 1224 may be provided at the inner lower end of the mounting groove 1221. The first hook insertion groove 1224 may be formed by the inner lower end of the mounting groove 1221 being recessed downward.

The rear cover 122 may include a second hook insertion groove 1225. While the mounting part 220 is mounted in the mounting groove 1221, the second hook insertion groove 1225 may allow at least a portion of the second hook 228 to be inserted therein. Specifically, while the mounting part 220 is mounted in the mounting groove 1221, the second inclined portion 2284 of the second hook 228 may be inserted into the second hook insertion groove 1225. With the second inclined portion 2284 being inserted into the second hook insertion groove 1225, the mounting part 220 may be mounted more stably on the display 100.

The second hook insertion groove 1225 may be provided at the other end of the mounting groove 1221. Specifically, the second hook insertion groove 1225 may be provided at the inner upper end of the mounting groove 1221. The second hook insertion groove 1225 may be formed by the inner upper end of the mounting groove 1221 being recessed upward.

According to the concept of the present disclosure, the length from the upper end of the second inclined portion 2284 to the lower end of the first inclined portion 2254 may be longer than the length by which the mounting groove 1221 extends in the upper-to-lower direction. On the other hand, the length from an upper surface 221k to a lower surface 221j of the case 221 may be equal to or shorter than the length by which the mounting groove 1221 extends in the upper-to-lower direction. With such a configuration, while the mounting part 220 is mounted in the mounting groove 1221, the mounting part 220 may be fixed inside the mounting groove 1221. Hereinafter, the length from the upper end of the second inclined portion 2284 to the lower end of the first inclined portion 2254 may be referred to as the maximum length of the mounting part 220, and the length by which the mounting groove 1221 extends in the upper-to-lower direction may be referred to as the length of the mounting groove 1221.

Hereinafter, a process of mounting the mounting part 220 in the mounting groove 1221 will be described with reference to FIGS. 19 to 28.

Referring to FIG. 20, in a state in which the mounting part 220 is separated from the mounting groove 1221, the first inclined portion 2254 may be located at a position lower than the lower surface 221j of the case 221. That is, the first inclined portion 2254 may be stepped from the lower surface 221j of the case 221.

Referring to FIG. 23, in a state in which the mounting part 220 is separated from the mounting groove 1221, the second inclined portion 2284 may be located at a position higher than the upper surface 221k of the case 221. That is, the second inclined portion 2284 may be stepped from the upper surface 221k of the case 221.

As described above, the maximum length of the mounting part 220 may be longer than the length of the mounting groove 1221. With such a configuration, when the mounting part 220 is mounted in the mounting groove 1221, the first inclined portion 2254 may come into contact with the first catching step 1226 provided at the lower end of the mounting groove 1221. As the mounting part 220 moves toward the inside of the mounting groove 1221, the first inclined portion 2254 may be moved upward by the first catching step 1226, thereby guiding the first hook 225 upward. That is, the first inclined portion 2254, which is provided at the lower end of the first hook 225, may guiding the first hook 225 upward. When the first hook 225 is guided and moved upward, the first elastic body 226 may be compressed.

When the mounting part 220 is mounted in the mounting groove 1221, the second inclined portion 2284 may come into contact with the second catching step 1227 provided at the upper end of the mounting groove 1221. As the mounting part 220 moves toward the inside of the mounting groove 1221, the second inclined portion 2284 may be moved downward by the second catching step 1227, thereby guiding the second hook 228 downward. That is, the second inclined portion 2284, which is provided at the upper end of the second hook 228, may guide the second hook 228 downward. When the second hook 228 is guided and moved downward, the second elastic body 229 may be compressed.

In a state in which the mounting part 220 is mounted in the mounting groove 1221, the first elastic body 226 may press the first hook 225 downward. That is, since the first elastic body 226 is disposed at the upper end of the first hook 225, the first elastic body 226 may press the first hook 225 downward. As the first hook 225 moves by being pressed downward, the first inclined portion 2254 may be inserted into the first hook insertion groove 1224.

In a state in which the mounting part 220 is mounted in the mounting groove 1221, the second elastic body 229 may press the second hook 228 upward. That is, since the second elastic body 229 is disposed at the lower end of the second hook 228, the second elastic body 229 may press the second hook 228 upward. As the second hook 228 moves by being pressed upward, the second inclined portion 2284 may be inserted into the second hook insertion groove 1225.

Hereinafter, a process of separating the mounting part 220 from the mounting groove 1221 will be described with reference to FIGS. 19 to 28.

As described above, the sliding part 227 may be movable up and down with respect to the case 221 together with the first hook 225. In addition, even while the mounting part 220 is mounted in the mounting groove 1221, the sliding part 227 may be movable up and down with respect to the case 221 together with the first hook 225.

When the sliding part 227 is moved upward, the first hook 225 may also move upward. As the first hook 225 moves upward, the first inclined portion 2254 may be withdrawn from the first hook insertion groove 1224. As the first inclined portion 2254 is withdrawn from the first hook insertion groove 1224, the fixation of the mounting part 220 with the mounting groove 1221 may be released. That is, the mounting part 220 may be separated from the mounting groove 1221. Accordingly, the mounting part 220 may be separated from the mounting groove 1221 through the upward movement of the sliding part 227.

According to the concept of the present disclosure, the stand 200 may be coupled to the display housing 120 only by the magnetic force between the first magnetic body 224 and the second magnetic body 1223 and the first and second hooks 225 and 228. That is, a separate fastening member, such as a screw, may not be required when coupling the stand 200 to the display housing 120. Therefore, it may be easier to couple the stand 200 to the display housing 120 or to separate the stand 200 from the display housing 120.

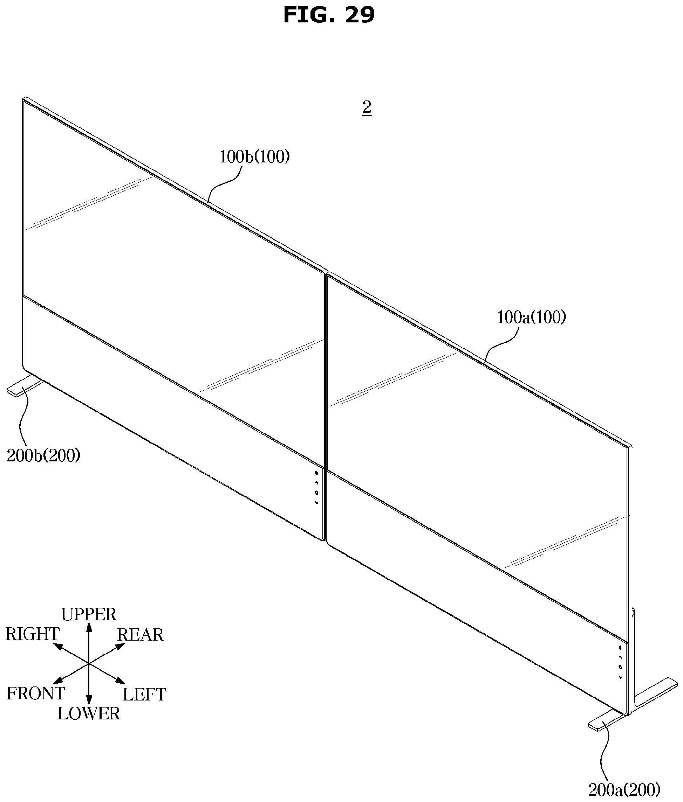

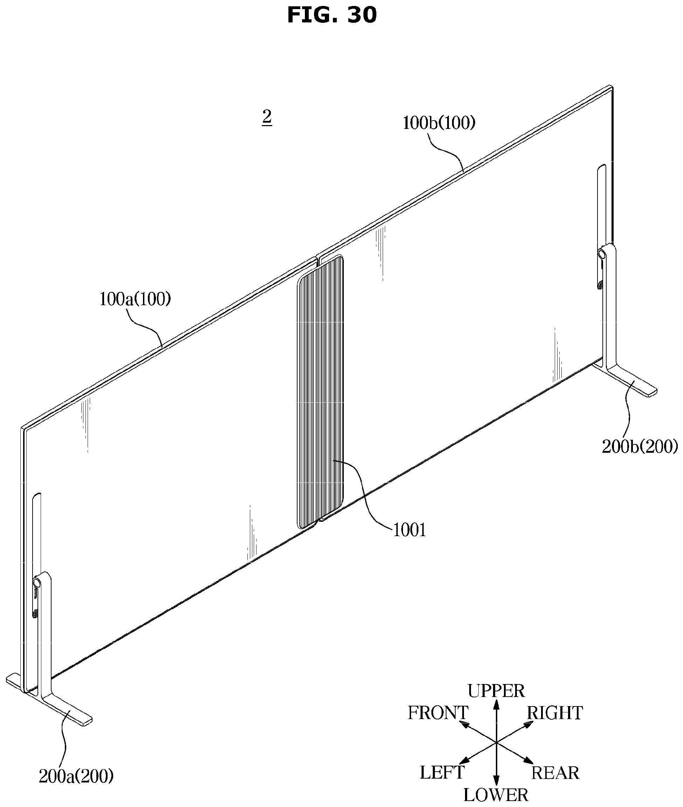

FIG. 29 is a view illustrating a display apparatus according to one or more embodiments. FIG. 30 is a view illustrating the display apparatus shown in FIG. 29, when viewed from the rear.

Hereinafter, a display apparatus 2 in which a plurality of displays 100 are provided will be described with reference to FIGS. 29 and 30. When describing the display apparatus 2, the same reference numerals may be assigned to components that are substantially the same as the components of the display apparatus 1 shown in FIGS. 1 to 28, and detailed descriptions may be omitted.

Referring to FIGS. 29 and 30, the display apparatus 2 may include a display 100. The display 100 may include a first display 100a and a second display 100b.

The first display 100a and the second display 100b may be connected through a display connecting part 1001. Specifically, the display connecting part 1001 may connect one side of the first display 100a and one side of the second display 100b. The display connecting part 1001 may be arranged at the rear of the display 100. With such a configuration, the display apparatus 2 may display characters, figures, graphs, images, etc. through a wider screen.

The stand 200 may be provided in plural. For example, the stand 200 may include a first stand 201 and a second stand 202. For example, the first stand 201 may be arranged at one end of the first display 100a. Specifically, the first stand 201 may be arranged at one end provided opposite to the one side of the first display 100a. For example, the second stand 202 may be arranged at one end of the second display 100b. Specifically, the second stand 202 may be arranged at one end provided opposite to the one side of the second display 100b. In the drawings, two stands 200 are illustrated, but the number of stands 200 is not limited thereto.

A display apparatus 1 according to one or more embodiments includes: a display 100; and a stand 200 configured to support the display 100. The stand 200 includes a mounting part 220 detachably mountable on the display 100, and a supporting part 210 rotatable to a locking position L in which movement of the supporting part 210 with respect to the mounting part 220 is restricted and an unlocking position U in which movement of the supporting part 210 with respect to the mounting part 220 is allowed. While the supporting part 210 is in the locking position L, the mounting part 220 is rotatable in a second direction B different from a first direction A in which the supporting part 210 rotates to the unlocking position U.

The mounting part 220 may include a guide portion 222 extending in an upper-to-lower direction while the mounting part 220 is mounted on the display 100. The supporting part 210 includes a connector 213 configured to be movably coupled to the guide portion 222 when the supporting part 210 is in the unlocking position U.

The mounting part 220 may include a fixing portion 223 configured to fix the connector 213 when the supporting part 210 is in the locking position L.

The supporting part 210 may further include a base 211 and a leg 212 extending from the base 211. The connector 213 further includes: a connector body 2131 provided on the guide portion 222; and a connecting protrusion 2132 extending from the connector body 2131 toward the leg 212, the connecting protrusion 2132 configured to connect the connector body 2131 and the leg 212.

The first direction A may be a direction in which the connector 213 rotates about a central axis of the connecting protrusion 2132.

The supporting part 210 may further include a hinge shaft 2142 extending in a direction intersecting with a direction in which the connecting protrusion 2132 extends, and the mounting part 220 may be rotatable about the hinge shaft 2142 in the second direction B together with the connector 213 when the supporting part 210 is in the locking position L.

The guide portion 222 may include a seating portion 2221 on which at least a portion of the connector body 2131 is seated; and a guide hole 2222 formed on an inner side of the seating portion 2221, through which the connecting protrusion 2132 passes.

The connector body 2131 may include a convex portion 2131a provided on an edge of the connector body 2131, and a concave portion 2231a, 2232a, 2233a configured to seat the convex portion 2131a thereon. While the convex portion 2131a is seated on the concave portion 2231a, 2232a, 2233a, the connector 213 may be fixed by the fixing portion 223.

The stand 200 may include a first stand 201 disposed at one end of the display 100, and a second stand 202 disposed at another end of the display 100.

The fixing portion 223 may include a first fixing portion 2231 configured to fix the mounting part 220 at a first height when the supporting part 210 is in the locking position **L,** and a second fixing portion 2232 configured to fix the mounting part 220 at a second height different from the first height when the supporting part 210 is in the locking position L.

The display 100 may include a display panel 110 and a rear cover 122 configured to cover a rear of the display panel 110. The rear cover 122 may include a mounting groove 1221 configured to mount the mounting part 220 therein.

The mounting part 220 may include a first magnetic body 224. The rear cover 122 may include a seating surface 1222 configured to seat the mounting part 220 thereon while the mounting part 220 is mounted in the mounting groove 1221, and a second magnetic body 1223 disposed on a side opposite to the mounting part 220 with respect to the seating surface 1222 while the mounting part 220 is mounted in the mounting groove 1221.

The mounting part 220 may further includes a hook 225 provided at one end of the mounting part 220. The rear cover 122 may further include a hook insertion groove 1224 provided at one end of the mounting groove 1221. At least a portion of the hook 225 may be configured to be inserted into the hook insertion groove 1224 while the mounting part 220 is mounted in the mounting groove 1221.

The mounting part 220 may include an elastic body 226 disposed at an upper end of the hook 225 to press the hook 225 downward while the mounting part 220 is mounted in the mounting groove 1221, and the hook 225 may include an inclined portion 2252 provided at a lower end of the hook 225 to guide the hook 225 upward when the mounting part 220 is mounted in the mounting groove 1221.

The mounting part 220 may further include a case 221 configured to accommodate at least a portion of the hook 225, and a sliding part 227 connected to the hook 225 and provided on an outer surface of the case 221. The sliding part 227 may be configured to move upward and downward with respect to the case 221 together with the hook 225 while the mounting part 220 is mounted in the mounting groove 1221.

A display apparatus 1 according to one or more embodiments includes: a display 100; and a stand 200 configured to support the display 100. The stand 200 includes: a mounting part 220 detachably mountable on the display 100, the mounting part 220 including a guide portion 222 extending in an upper-to-lower direction while the mounting part 220 is mounted on the display 100, and a fixing portion 223 on the guide portion 222; and a supporting part 210 including a connector 213 configured to be movably coupled to the guide portion 222. The connector 213 is configured to be fixed to the fixing portion 223 or be released from the fixing portion 223 by rotating on the fixing portion 223 in one direction.

The supporting part 210 may further include a base 211 and a leg 212 extending from the base 211. The connector 213 may further include: a connector body 2131 provided on the guide portion 222; and a connecting protrusion 2132 extending from the connector body 2131 toward the leg 212, the connecting protrusion 2132 configured to connect the connector body 2131 and the leg 212. The direction in which the connector 213 rotates may be the direction in which the connector 213 rotates about the central axis of the connecting protrusion 2132.

While the connector 213 is fixed to the fixing portion 223, the direction in which the guide portion 222 extends may be parallel to the direction in which the leg 212 extends.

While the connector 213 is released from the fixing portion 223, the direction in which the guide portion 222 extends and the direction in which the leg 212 extends may be perpendicular to each other.

The fixing portion 223 may include a first fixing portion 2231 arranged at an upper end of the guide portion 222 while the mounting part 220 is mounted on the display 100, and a second fixing portion 2232 arranged at a lower end of the guide portion 222 while the mounting part 220 is mounted on the display 100.

According to the concept of the present disclosure, attaching and detaching a stand to and from a display can be facilitated using a magnetic body and a hook structure, thereby improving the usability of the display apparatus.

According to the concept of the present disclosure, two stands are arranged at each end of the display, and thus the load received by each stand can be reduced. Accordingly, the display apparatus can stably support the display even when the stand has a relatively small size.

According to the concept of the present disclosure, the display apparatus can adjust the height of the display through the rotation and up-and-down movement of the supporting part. In addition, the display apparatus can adjust the angle of the display through the hinge structure.

The effects of the present disclosure are not limited to the effects described above, and other effects that are not described will be clearly understood by those skilled in the art from the following description.

While the disclosure has been illustrated and described with reference to one or more embodiments, it will be understood that the one or more embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiments described herein may be used in conjunction with any other embodiments described herein.

## Claims

1. A display apparatus comprising:
a display; and
a stand configured to support the display,
wherein the stand comprises:
a mounting part detachably mountable on the display; and
a supporting part rotatable in a first direction to a locking position or an unlocking position,
wherein a movement of the supporting part with respect to the mounting part is restricted in a state in which the supporting part is in the locking position,
wherein the movement of the supporting part with respect to the mounting part is allowed in a state in which the supporting part is in the unlocking position, and
wherein in a state in which the supporting part is in the locking position, the mounting part is rotatable in a second direction different from the first direction.

2. The display apparatus of claim 1, wherein the mounting part comprises a guide portion extending in an upper-lower direction in a state in which the mounting part is mounted on the display, and
wherein the supporting part comprises a connector configured to be movably coupled to the guide portion in a state in which the supporting part is in the unlocking position.

3. The display apparatus of claim 2, wherein the mounting part comprises a fixing portion configured to fix the connector to a fixed position in a state in which the supporting part is in the locking position.

4. The display apparatus of claim 3, wherein the supporting part further comprises:
a base; and
a leg extending from the base, and
wherein the connector further comprises:
a connector body on the guide portion; and
a connecting protrusion extending from the connector body toward the leg and configured to connect the connector body to the leg.

5. The display apparatus of claim 4, wherein the first direction is a direction in which the connector rotates about a central axis of the connecting protrusion.

6. The display apparatus of claim 4, wherein the supporting part further comprises a hinge shaft extending in a direction intersecting with a direction in which the connecting protrusion extends, and
wherein the second direction is a direction in which the mounting part rotates about a central axis of the hinge shaft together with the connector in a state in which the supporting part is in the locking position.

7. The display apparatus of claim 4, wherein the guide portion comprises:
a seating portion; and
a guide hole on an inner side of the seating portion,
wherein at least a portion of the connector body is seated on the seating portion, and
wherein the connecting protrusion passes through the guide hole.

8. The display apparatus of claim 4, wherein the connector body comprises:
a convex portion on an edge of the connector body; and
a concave portion configured to seat the convex portion thereon, and
wherein in a state in which the convex portion is seated on the concave portion, the connector is fixed to the fixed position by the fixing portion.

9. The display apparatus of claim 1, wherein the stand comprises:
a first stand disposed at one end of the display; and
a second stand disposed at another end of the display.

10. The display apparatus of claim 3, wherein the fixing portion comprises:
a first fixing portion configured to fix the mounting part at a first height in a state in which the supporting part is in the locking position; and
a second fixing portion configured to fix the mounting part at a second height different from the first height in a state in which the supporting part is in the locking position.

11. The display apparatus of claim 1, wherein the display comprises a display panel and a rear cover configured to cover a rear of the display panel, and
wherein the rear cover comprises a mounting groove configured to mount the mounting part therein.

12. The display apparatus of claim 11, wherein the mounting part comprises a first magnetic body, and
wherein the rear cover comprises:
a seating surface configured to seat the mounting part thereon in a state in which the mounting part is mounted in the mounting groove; and
a second magnetic body disposed on a side opposite to the mounting part with respect to the seating surface in a state in which the mounting part is mounted in the mounting groove.

13. The display apparatus of claim 11, wherein the mounting part further comprises a hook at one end of the mounting part,
wherein the rear cover further comprises a hook insertion groove at one end of the mounting groove, and
wherein at least a portion of the hook is configured to be inserted into the hook insertion groove in a state in which the mounting part is mounted in the mounting groove.

14. The display apparatus of claim 13, wherein the mounting part comprises an elastic body at an upper end of the hook and configured to press the hook downward in a state in which the mounting part is mounted in the mounting groove, and
wherein the hook comprises an inclined portion at a lower end of the hook and configured to guide the hook upward in a state in which the mounting part is mounted in the mounting groove.

15. The display apparatus of claim 13, wherein the mounting part further comprises:
a case configured to accommodate at least a portion of the hook; and
a sliding part connected to the hook and provided on an outer surface of the case, and
wherein the sliding part is configured to move upward and downward with respect to the case together with the hook in a state in which the mounting part is mounted in the mounting groove.
